(19) Europäisches Patentamt
European Patent Office
Office européen des brevets

(11) EP 2 499 277 B1

(12) **EUROPEAN PATENT SPECIFICATION**

(45) Date of publication and mention of the grant of the patent:
**27.09.2017 Bulletin 2017/39**

(21) Application number: **10776513.3**

(22) Date of filing: **08.11.2010**

(51) Int Cl.:
***C23C 18/06*** (2006.01) ***C23C 18/08*** (2006.01)
***C09D 11/10*** (2014.01) ***C07F 1/00*** (2006.01)
***C07F 9/50*** (2006.01) ***C09D 11/101*** (2014.01)
***C09D 11/52*** (2014.01) ***C09D 11/322*** (2014.01)
*H05K 3/10* (2006.01) *H05K 3/12* (2006.01)

(86) International application number:
**PCT/US2010/055874**

(87) International publication number:
**WO 2011/057218 (12.05.2011 Gazette 2011/19)**

(54) **METAL INK COMPOSITIONS, CONDUCTIVE PATTERNS, METHODS, AND DEVICES**

METALLTINTENZUSAMMENSETZUNGEN, LEITENDE STRUKTUREN, VERFAHREN UND VORRICHTUNGEN

COMPOSITIONS D'ENCRES MÉTALLIQUES, MOTIFS CONDUCTEURS, PROCÉDÉS, ET DISPOSITIFS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.11.2009 US 259614 P**

(43) Date of publication of application:
**19.09.2012 Bulletin 2012/38**

(73) Proprietor: **Carnegie Mellon University**
**Pittsburgh, PA 15213 (US)**

(72) Inventors:
- **MCCULLOUGH, Richard, D.**
**Pittsburgh**
**Pennsylvania 15238 (US)**
- **BELOT, John, A.**
**Pittsburgh, Pennsylvania 15213 (US)**
- **JAVIER, Anna**
**Pittsburgh, Pennsylvania 15213 (US)**
- **POTASH, Rebecca**
**Pittsburgh, Pennsylvania 15213 (US)**

(74) Representative: **Lahrtz, Fritz**
**Isenbruck Bösl Hörschler LLP**
**Patentanwälte**
**Prinzregentenstraße 68**
**81675 München (DE)**

(56) References cited:
**GB-A- 1 517 608** **US-A- 6 010 969**
**US-A- 6 033 735** **US-A1- 2003 124 457**
**US-A1- 2003 148 024** **US-A1- 2003 207 568**

- **JOHN P. FACKLER ET AL: "Decarboxylation of (triphenylphosphine)gold(I) carboxylates", ORGANOMETALLICS, vol. 10, no. 7, 1 July 1991 (1991-07-01), pages 2178-2183, XP55006238, ISSN: 0276-7333, DOI: 10.1021/om00053a021**
- **LIU Z ET AL: "Inkjet-printed silver conductors using silver nitrate ink and their electrical contacts with conducting polymers", THIN SOLID FILMS, ELSEVIER-SEQUOIA S.A. LAUSANNE, CH, vol. 478, no. 1-2, 1 May 2005 (2005-05-01) , pages 275-279, XP004774133, ISSN: 0040-6090, DOI: 10.1016/J.TSF.2004.11.077**
- **YILIANG WU ET AL: "A Simple and Efficient Approach to a Printable Silver Conductor for Printed Electronics", JOURNAL OF THE AMERICAN CHEMICAL SOCIETY, vol. 129, no. 7, 1 February 2007 (2007-02-01), pages 1862-1863, XP55013718, ISSN: 0002-7863, DOI: 10.1021/ja067596w**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

INTRODUCTION

Printed electronics is projected to be a multi-billion business within the next 7-10 years, with the inks alone constituting 10-15% of the dollar amount, according to some sources. The increased interest in printable electronics as rapidly growing alternatives to silicon-based technologies is fueled by, among other things, the promise of large-area, flexible, lightweight and low-cost devices.
More particularly, a need exists for better methods for printing metals such as, for example, copper, silver, and gold. These metals are important chip components ranging from interconnects to organic field effect transistor source and drain electrodes. In general, improved compositions and methods for producing metal structures are needed, particularly for commercial applications and inkjet printing. See, for example, U.S. Patent Nos. 7,270,694; 7,443,027; 7,491,646; 7,494,608 (assignee: Xerox); US Patent Publication 2010/0163810 ("Metal Inks"); US Patent Publication 2008/0305268 ("Low Temperature Thermal Conductive Inks"); and US Patent Publication 2006/0130700 ("Silver Containing Inkjet Inks").

## SUMMARY

The present invention is directed to a composition comprising at least one metal complex comprising at least one metal and at least two ligands, wherein the metal is silver, wherein at least one first ligand is a sigma donor to the metal and volatilizes upon heating the metal complex, wherein the first ligand is an amine compound comprising at least two nitrogen, and at least one second ligand different from the first which also volatilizes upon heating the metal complex, wherein the second ligand is an isobutyrate ligand, wherein the metal complex is soluble in a solvent at 25°C and wherein the metal complex comprises at least 25 wt.% metal. Furthermore, the present invention is directed to a method comprising depositing an ink on a surface, wherein the ink comprises a composition of the present invention and producing a conductive metal film by heating or irradiating said ink.
Provided herein are also compositions, devices, methods of making compositions and devices, and methods of using compositions and devices, among other embodiments.
Further disclosed is a composition A comprising at least one metal complex comprising at least one metal and at least two ligands, wherein at least one first ligand is a sigma donor to the metal and volatilizes upon heating the metal complex, and at least one second ligand different from the first which also volatilizes upon heating the metal complex, wherein the metal complex is soluble in a solvent at 25°C. Methods of making, formulating, and using this composition also are provided for embodiment A and sub-embodiments thereof.
Further disclosed is a composition, wherein the metal is silver, gold, copper, platinum, or ruthenium.
Further disclosed is a composition, wherein the metal is silver, gold, or copper.
Further disclosed is a composition, wherein the metal is silver or gold.
In one embodiment, the metal complex comprises only one metal center.
In one embodiment, the metal is in an oxidation state of (I) or (II).
In one embodiment, the first ligand is a monodentate ligand.
In one embodiment, the first ligand is a bidentate ligand.
In one embodiment, the first ligand is a tridentate ligand.
The first ligand is an amine compound comprising at least two nitrogen.
In one embodiment, the first ligand is an unsymmetrical amine compound comprising at least two nitrogen.
Further disclosed is a composition, wherein the first ligand is tetrahydrothiophene or an amine.
Further disclosed is a composition, wherein the the first ligand is a thioether. The thioether can be cylic or linear.
In one embodiment, the first ligand is not a phosphine.
Further disclosed is a composition, wherein the second ligand is a carboxylate.
Further disclosed is a composition, wherein the second ligand is a carboxylate comprising an alkyl group.
Further disclosed is a composition, wherein the second ligand is a carboxylate represented by -OOC-R, wherein R is an alkyl group, wherein R has 10 or fewer carbon atoms.
Further disclosed is a composition, wherein the second ligand is a carboxylate represented by -OOC-R, wherein R is an alkyl group, wherein R has 5 or fewer carbon atoms.
In one embodiment, the composition is substantially free of nanoparticles.
In one embodiment, the composition is totally free of nanoparticles.
In one embodiment, the composition has a sharp decomposition transition beginning at a temperature of less than 200°C.
In one embodiment, the composition has a sharp decomposition transition beginning at a temperature of less than 150°C.

In one embodiment, the composition can be stored at about 25°C for at least 100 hours without substantial deposition of metal (0).

In one embodiment, the composition further comprises at least one solvent for the complex.

In one embodiment, the composition further comprises at least one aromatic hydrocarbon solvent.

In one embodiment, the composition further comprises at least one solvent, and the concentration of the complex is about 200 mg/mL or less.

In one embodiment, the solvent is an aromatic hydrocarbon solvent.

The metal complex comprises at least 25 wt.% metal.

In one embodiment, the metal complex comprises at least 50 wt.% metal.

In one embodiment, the metal complex comprises at least 70 wt.% metal.

Further described is a composition, wherein the second ligand is a carboxylate, and the first ligand is a polydentate amine, and the metal is silver, gold, or copper.

Further described is a composition, wherein the second ligand is a carboxylate, the first ligand is a polydentate unsymmetrical amine, the metal is silver or gold, and wherein the solvent is toluene.

Further disclosed is a composition B comprising at least one metal complex comprising at least one metal and at least two ligands, wherein at least one first ligand is a sulfur-containing ligand, and at least one second ligand different from the first which, optionally, is a carboxylate, wherein the metal complex is soluble in a solvent at 25°C. Methods of making, formulating, and using this composition also are provided for

the latter composition and sub-compositions thereof. The composition can be substantially free of nanoparticles.

Further described is a composition, wherein the second ligand is a carboxylate; i.e., the carboxylate is not optional.

Further described is a composition, wherein the content of metal in the complex is at least 50 wt.%.

Further described is a composition, wherein the sulfur-containing ligand is a thioether ligand. The thioether can be cyclic or linear.

Further described is a composition, wherein the sulfur containing ligand is tetrahydrothiophene. Further described is a composition, wherein the sulfur-containing ligand is a dialkylthioether. Further described is a composition, wherein the sulfur-containing ligand is a dithiaalkane.

Further described is a composition, wherein the sulfur-containing ligand is a dithioctane.

Further described is a composition, wherein the sulfur-containing ligand comprises one or two sulfur atoms.

Further described is a composition, wherein the sulfur-containing ligand is a bidentate ligand. Further described is a composition, wherein the sulfur-containing ligand has six carbons or less, or four carbons or less, or two carbons or less.

Further disclosed is a composition C comprising at least one metal complex comprising at least one metal and at least two ligands, wherein at least one first ligand is an amino ligand, and at least one second ligand different from the first which, optionally, is a carboxylate, wherein the metal complex is soluble in a solvent at 25°C. Methods of making, formulating, and using this composition also are provided for the latter composition and sub-compositions thereof. The composition can be substantially free of nanoparticles.

Further described is a composition, wherein the content of metal in the complex is at least 50 wt.%.

Further described is a composition, wherein the second ligand is a carboxylate.

Further described is a composition, wherein the metal is silver, gold, copper, platinum, or ruthenium.

Further described is a composition, wherein the metal complex comprises only one metal center.

Further described is a composition, wherein the metal is in an oxidation state of (I) or (II).

Further described is a composition, wherein the first ligand is a monodentate ligand.

Further described is a composition, wherein the first ligand is a bidentate ligand.

Further described is a composition, wherein the first ligand is a tridentate ligand.

Further described is a composition, wherein the first ligand is an unsymmetrical amino ligand comprising at least two nitrogen.

Further described is a composition, wherein the first ligand is an unsymmetrical amino ligand comprising at least two nitrogen.

Further disclosed is a composition D comprising at least one neutral metal complex comprising at least one metal in a (I) or (II) oxidation state, and at least two ligands, wherein at least one first ligand is a neutral sigma donor to the metal and volatilizes upon heating the metal complex to a temperature below 150°C, and at least one second anionic ligand different from the first which also volatilizes upon heating the metal complex to a temperature below 150°C, wherein, optionally, the metal complex is soluble in a solvent at 25°C. Methods of making, formulating, and using this composition also are provided for the latter composition and sub-compositions thereof.

Further described is a composition, wherein the first ligand is a sulfur-containing ligand. Further described is a composition, wherein the first ligand is tetrahydrothiophene.

Further described is a composition, wherein the first ligand is a thioether. The thioether can be cyclic or linear.
Further described is a composition, wherein the first ligand comprises at least two sulfurs. Further described is a composition, wherein the first ligand has six of fewer carbon atoms. Further described is a composition, wherein the first ligand has four or fewer carbon atoms. Further described is a composition, wherein the first ligand has two or fewer carbon atoms. Further described is a composition, wherein the first ligand second ligand is a carboxylate.
Further described is a composition, wherein the number of carbon atoms in the complex is twelve or less.

Further disclosed is a method comprising: depositing an ink on a surface, wherein the ink comprises a composition as claimed or described herein, and producing a conductive metal film by heating or irradiating said ink.
In one embodiment, the producing step is carried out by heating.
In one embodiment, the producing step is carried out by irradiating.
Further described is a method, wherein the ink comprises a composition according to composition A and sub-compositions thereof.
Further described is a method, wherein the ink comprises a composition according to composition B and sub-compositions thereof.
Further described is a method, wherein the ink comprises a composition according to composition C and sub-compositions thereof.
Further described is a method, wherein the ink comprises a composition according to composition D and sub-compositions thereof.
Further described is a method, wherein the metal is gold, silver, or copper.

In one embodiment, the ink is substantially free of nanoparticles before deposition.

In one embodiment, the ink is substantially free of nanoparticles after deposition.

In one embodiment, the depositing is carried out by inkjet deposition.

In one embodiment, the producing is carried out by heating at a temperature of about 250°C or less.

In one embodiment, the producing is carried out by heating at a temperature of about 200°C or less.

In one embodiment, the producing is carried out by heating at a temperature of about 150°C or less.

In one embodiment, the film is in the form of a line, and the line has a conductivity of at least 1,000 S/cm.

In one embodiment, the film is in the form of a line, and the line has a conductivity of at least 5,000 S/cm.

In one embodiment, the film is in the form of a line, and the line has a conductivity of at least 10,000 S/cm.

In one embodiment, the film is in the form of a line, and the line has a work function which is within 25 percent of the work function of the pure metal.

In one embodiment, the film is in the form of a line, and the line has a work function which is within 10 percent of the work function of the pure metal.

In one embodiment, the film is in the form of a line, and the line has a work function which is within 5 percent of the work function of the pure metal..

Another embodiment provides a method comprising: depositing an ink on a surface to form a deposit, converting the deposit to a metal film, wherein the metal film shows a work function which is within 25 percent of the work function of the pure metal.

In one embodiment, the deposit is heated.

In one embodiment, the deposit is irradiated.

In one embodiment, the ink comprises a composition according to embodiments described herein.
Further described is a method, wherein the ink comprises a composition according to composition A and sub-compositions thereof.
Further described is a method, wherein the ink comprises a composition according to composition B and sub-compositions thereof.
Further described is a method, wherein the ink comprises a composition according to composition C and sub-compositions thereof.
Further described is a method, wherein the ink comprises a composition according to composition D and sub-compositions thereof.

Further described is a method, wherein the metal is gold, silver, or copper.

In one embodiment, the ink is substantially free of nanoparticles before deposition.

In one embodiment, the ink is substantially free of nanoparticles after deposition.

In one embodiment, the depositing is carried out by inkjet deposition.

In one embodiment, the converting is carried out by heating at a temperature of about 250°C or less.

In one embodiment, the converting is carried out by heating at a temperature of about 200°C or less.

In one embodiment, the converting is carried out by heating at a temperature of about 150°C or less.

In one embodiment, the film is in the form of a line, and the line has a conductivity of at least 1,000 S/cm.

In one embodiment, the film is in the form of a line, and the line has a conductivity of at least 5,000 S/cm.

In one embodiment, the film is in the form of a line, and the line has a conductivity of at least 10,000 S/cm.

In one embodiment, the film is in the form of a line, and the line has a work function which is within 10 percent of the work function of the pure metal.

In one embodiment, the film is in the form of a line, and the line has a work function which is within 5 percent of the work function of the pure metal.

Further described is a composition comprising at least one metal complex comprising at least one metal and at least two ligands, wherein at least one first ligand is a sigma donor to the metal and volatilizes upon heating the metal complex, and at least one second ligand which also volatilizes upon heating the metal complex, wherein the metal complex is soluble in a solvent at 25°C.

Further described is a composition, wherein the first ligand and the second ligand are the same ligand. Further described is a composition, wherein the first ligand and the second ligand are different ligands.

Further described is a composition, wherein the metal is copper. Further described are compositions, wherein the metals can also be, for example, silver, gold, platinum, or ruthenium. Further described is a composition, wherein the first ligand comprises at least one nitrogen atom and at least two oxygen atoms.

Further described is a composition, wherein the first ligand and the second ligand are the same ligand, and wherein the first ligand comprises at least one nitrogen atom and at least two oxygen atoms. Further described is a composition, wherein the first ligand and the second ligand are the same ligand, and wherein the first ligand comprises at least one nitrogen atom and at least two oxygen atoms, as well as at least one fluorine.

Further described is a composition, wherein the first ligand is a tridentate ligand.

Further described is a composition, wherein the first ligand is a tridentate Schiff base ligand Further described is a composition, wherein the first ligand comprises at least one secondary amine group, at least one carbonyl group, ant at least one ether group.

Further described are compositions, wherein the compositions consist essentially of ingredients and components described herein.

Further described is a composition comprising at least one metal complex comprising at least one metal and at least two ligands, wherein at least one first ligand is a sigma donor to the metal and volatilizes upon heating the metal complex to a temperature of about 250°C or less, and at least one second ligand, which is optionally different from the first, which also volatilizes upon heating the metal complex to a temperature of about 250°C or less.

Further disclosed is a composition, wherein the metal complex is heated to a temperature of 150°C or less. Further disclosed is a composition, wherein the metal complex is soluble at 25°C.

Further disclosed is a composition, wherein the composition upon heating provieds a metal with a work function which is within 25 percent of the work function of the pure metal.

Further disclosed is a composition, wherein the composition upon heating provides a metal composition having a conductivity of at least 1,000 S/cm.

Further disclosed is a method comprising: depositing an ink on a surface to form a deposit, converting the deposit to a metal film, wherein the metal film shows a conductivity of at least 1,000 S/cm.

Further disclosed is a method, wherein the conductivity is at least 5,000 S/cm.

Further disclosed is a method, wherein the conductivity is at least 10,000 S/cm.

Further disclosed is a method, wherein the converting is carried out by heating at a temperature of about 200°C or less.

Further disclosed is a method, wherein the converting is carried yout by heating at a temperature of about 150°C or less.

Further disclosed is a composition comprising at least one metal complex consisting essentially of at least one metal and at least two ligands bonded to the metal, wherein at least one first ligand is a neutral donor to the metal and volatilizes upon heating the metal complex, and at least one second ligand different from the first which also volatilizes upon heating the metal complex and is negatively charged.

Further disclosed is a composition, wherein the first ligand consists essentially of nitrogen and/or sulfur.

Further disclosed is a composition, wherein the second ligand consists essentially of a carboxylate.

Further disclosed is a composition, wherein the complex is soluble in toluene.

Further disclosed is a composition, wherein the complex consisting essentially of the metal, the first ligand, and the second ligand is neutrally charged.

At least one advantage for at least one embodiment is ability to make useful conductive metal lines and films of high quality. At least one additional advantage for at least one embodiment is the low temperature nature of the conversion to conductive metal. At least one additional advantage for at least one embodiment is the high metal content of the metal inks. At least one additional advantage for at least one embodiment is the high conductivity of metal films. Furthermore, at least one additional advantage for at least one embodiment is ability to be inkjet printed.

Other advantages for at least some embodiments include aspects described below.

BRIEF DESCRIPTION OF FIGURES

Figure 1 illustrates one embodiment, showing a diffraction-derived molecular structure of a gold complex.
Figure 2 illustrates one embodiment in a perspective view, showing an AFM image of well-separated Au nanoparticles in a triphenylphosphine oxide matrix.
Figure 3 illustrates one embodiment, showing a thermogravimetric analysis of a gold complex.
Figure 4 illustrates one embodiment, showing a diffraction-derived molecular structure of a dinuclear silver complex.
Figure 5 illustrates one embodiment, showing a diffraction-derived molecular structure of a mononuclear silver complex.
Figure 6 illustrates one embodiment, showing the log resistivity versus temperature plot of a (DEED)Ag(isobutyrate) line drawn between two gold electrode pads on $Si/SiO_2$ from a 65 mg/mL toluene solution.
Figure 7 illustrates one embodiment in a top view, showing a scanning electron microscopy image of deposited metallic silver.
Figure 8 illustrates one embodiment, showing energy dispersive x-ray spectroscopy of deposited metallic silver.
Figure 9 illustrates one embodiment in a top view, showing an inkjet deposition of silver ink.
Figure 10 illustrates one embodiment, showing the log resistivity (arbitrary units) versus temperature plot (°C) of a (DEED)Ag(cyclopropate) line drawn between two gold electrode pads on $Si/SiO_2$ from a 65 mg/mL toluene solution.
Figure 11 illustrate one embodiment, showing the log resistivity (arbitrary units) versus temperature (°C) plot of a (PMDEA)Ag(isobutyrate) line drawn between two gold electrode pads on $Si/SiO_2$ from a 65 mg/mL toluene solution.
Figure 12 illustrate one embodiment, showing the log resistivity (arbitrary units) versus temperature (°C) plot of a copper complex.
Figure 13 illustrates one embodiment in a top view, showing a scanning electron microscopy image of copper lines drawn on a $SiO_2$ substrate.
Figure 14 illustrates one embodiment, showing energy dispersive x-ray spectroscopy of copper lines drawn on a $SiO_2$ substrate.
Figure 15 illustrates one embodiment, showing a diffraction-derived molecular structure of a silver complex.
Figure 16 illustrates one embodiment, showing XPS of Au film formed from precursor solution and evolution with sputtering cleaning steps for Au4f, Ag3d, C1s, and O1s.
Figure 17 illustrates one embodiment, showing work function of Au from the precursor (4.9 eV).
Figure 18 illustrates one embodiment, showing a diffraction-derived molecular structure of a silver complex.
Figure 19 illustrates one embodiment, showing the log resistivity (arbitrary units) versus temperature (°C) plot of a silver line drawn between two gold electrode pads.
Figure 20 illustrates one embodiment in a top view, showing a image of a silver line drawn between two gold electrode pads.
Figure 21 illustrates one embodiment, showing procedures of synthesizing of gold complexes.
Figure 22 illustrates one embodiment in a perspective view, showing a micro-casting setup.
Figure 23 illustrates one embodiment, showing the log resistivity (arbitrary units) versus temperature (°C) plot for metallization of gold solution.
Figure 24 illustrates one embodiment in a top view, showing a (low resolution) scanning electron microscopy image of a gold line drawn between two gold electrode pads prepared by lithography.
Figure 25 illustrates one embodiment, showing energy dispersive x-ray spectroscopy of a gold line drawn between two gold electrode pads.
Figure 26 illustrates one embodiment in a top view, showing inkjet printed gold lines.
Figure 27 illustrates one embodiment, comparing XPS Au peaks for Au films prepared from (A) precursor solution and (B) using sputter deposition.
Figure 28 illustrates one embodiment, showing conductivity from liquid gold.
Figure 29 illustrates one embodiment, showing diffraction-derived molecular structure of a trinuclear gold complex.
Figures include, in some cases, color figures and features, and the color features form part of the disclosure.

DETAILED DESCRIPTION

INTRODUCTION

Microfabrication, printing, ink jet printing, electrodes, and electronics are described in, for example, Madou, Fundamentals of Microfabrication, The Science of Miniaturization, 2nd Ed., 2002.
Organic chemistry methods and structures are described in, for example, March's Advanced Organic Chemistry,

6th Ed., 2007.

Organometallic precursors for forming metal patterns and methods of forming metal patterns using the same are described e.g. in US 2003/0207568 A1.

To help enable the growing demands of printing processes and other applications, new metal-containing inks are provided herein for the solution-based deposition of conductive metal films, including coinage metal films, including, for example, copper, silver, and gold films. The metallizing ink approach provided herein is based on coordination chemistry and self-reducing ligands that can be, for example, heated or photochemically irradiated to yield metallic films.

Patterning methods including, for example, inkjet printing, can be employed to deposit the metal inks in specific, predetermined patterns which can be directly transformed into, for example, circuitry using a laser or simple heating, including low temperature heating.

The versatility of this approach provides printing a variety of designs and patterns on a variety of substrates for much cheaper than conventional deposition methods without the need for lithography.

Herein, a composition can comprise at least one metal complex, as well as optional other components including, for example, solvent. In one embodiment, the composition does not comprise a polymer. In one embodiment, the composition does not comprise a surfactant. In one embodiment, the composition comprises only metal complex and solvent.

In formulating compositions, examples of prerequisite synthetic criteria include, for example: (1) compounds can be air- and moisture stable, (2) compounds can show longevity and can be stored for long periods or indefinitely, (3) synthesis of the compounds is amenable to the large scale while being inexpensive with high yields, (4) compounds are soluble in aromatic hydrocarbons, such as toluene and xylenes, which are compatible with printing processes such as inkjet and Patch pipette, and/or (5) compounds should cleanly decompose, either thermally or photochemically, to base metal.

METAL COMPLEX

The metal complex can be a precursor to a metal film. Metal organic and transition metal compounds, metal complexes, metals, and ligands are described in, for example, Lukehart, Fundamental Transition Metal Organometallic Chemistry, Brooks/Cole, 1985; Cotton and Wilkinson, Advanced Inorganic Chemistry: A Comprehensive Text, 4th Ed., John Wiley, 2000. The metal complex can be homoleptic or heteroleptic. The metal complex can be mononuclear, dinuclear, trinuclear, and higher. The metal complex can be a covalent complex.

The metal complex can be free from metal-carbon bonding.

The metal complex can be as a whole uncharged so there is not a counterion which is not directly bonding to the metal center. For example, in one embodiment, the metal complex is not represented by $[M]^+[A]^-$ wherein the metal complex and its ligands are a cation. In one embodiment, the metal complex can be represented by $ML_1L_2$, wherein $L_1$ and $L_2$ are the first and second metal ligands, respectively. M here may have a positive charge which is balanced by a negative charge from $L_1$ or $L_2$.

The metal complex can be free from anions such as halide, hydroxide, cyanide, nitrite, nitrate, nitroxyl, azide, thiocyanato, isothiocyanato, tetraalkylborate, tetrahaloborate, hexafluorophosphate, triflate, tosylate, sulfate, and/or carbonate.

In one embodiment, the metal complex is free of fluorine atoms, particularly for silver and gold complexes.

The composition comprising the metal complex can be substantially or totally free of particles, microparticles, and nanoparticles. In particular, the composition comprising the metal complex can be substantially or totally free of nanoparticles including metal nanoparticles, or free of colloidal material. See, for example, US Patent No. 7,348,365 for colloidal approaches to form conductive inks. For example, the level of nanoparticles can be less than 0.1 wt.%, or less than 0.01 wt.%, or less than 0.001 wt. %. One can examine composition for particles using methods known in the art including, for example, SEM and TEM, spectroscopy including UV-Vis, plasmon resonance, and the like. Nanoparticles can have diameters of, for example, 1 nm to 500 nm, or 1 nm to 100 nm.

The composition comprising the metal complex can be also free of flakes.

In some embodiments, the composition can comprise at least two different metal complexes.

The metal complexes can be also adapted for use in forming materials like oxides and sulfides, including ITO and ZnO.

In one embodiment, the metal complex is not an alkoxide such as a copper alkoxide (e.g., absence of M-O-R linkage).

SOLUBILITY

The metal complex can be soluble, which facilitates further processing. It can be soluble in, for example, in a non-polar or less polar solvent such as a hydrocarbon, including an aromatic hydrocarbon solvent. Aromatic hydrocarbon solvent includes benzene and toluene. Another example is a xylene or mixtures of xylenes. Polyalkylaromatics can be

used.

The composition comprising metal complex can further comprise at least one solvent for the complex including at least one aromatic hydrocarbon solvent. An oxygenated solvent can be substantially or totally excluded including, for example, water, alcohols, glycols including ethylene glycol, polyethers, aldehydes, and the like.

The composition comprising metal complex can further comprise at least one solvent, and the concentration of the complex can be about 200 mg/mL or less, or about 100 mg/mL or less, or about 50 mg/mL or less.

In one embodiment, the metal complex is used without a solvent.

In one embodiment, the composition is free of, or substantially free of water. For example, the amount of water can be less than 1 wt.%. Or, the amount of water can be less than 0.1 wt.% or less than 0.01 wt.%.

In one embodiment, the composition is free of, or substantially free of oxygenated solvent. For example, the amount of oxygenated solvent can be less than 1 wt.%. Or, the amount of oxygenated solvent can be less than 0.1 wt.% or less than 0.01 wt.%.

METAL CENTER

Metals and transition metals are known in the art. See, for example, Cotton and Wilkinson text, cited above. Coinage metals can be used including silver, gold, and copper. Platinum can be used. Nickel, cobalt, and palladium can be used. Lead, iron, and tin can be used, for example. Ruthenium can be used. Other examples of metals used for conductive electronics are known and can be used as appropriate. Mixtures of metal complexes with different metals can be used. Alloys can be formed.

The metal complex can comprise only one metal center. Or the metal comples can comprise only one or two metal centers.

The metal can be in an oxidation state of (I) or (II).

The metal center can be complexed with first and second ligands. Additional ligands, third, fourth, and the like can be used.

The metal center can be complexed at multiple sites including complexed with three, four, five, or six complexing sites.

The metal center can comprise a metal useful for forming electrically conducting lines, particularly those metals used in the semiconductor and electronics industries.

Still other examples of metals include indium and tin.

FIRST LIGAND

The first ligand can provide sigma electron donation, or dative bonding, to the metal. Sigma donation is known in the art. See, for example, US Patent No. 6,821,921. The first ligand can be adapted to volatilize when heated without formation of a solid product. Heating can be done in the presence or absence of oxygen. The first ligand can be a reductant for the metal. The first ligand can be in neutral state, not an anion or a cation.

The first ligand can be a polydentate ligand including, for example, a bidentate or a tridentate ligand.

The first ligand is an amine compound comprising at least two nitrogen. The ligand can be symmetrical or unsymmetrical.

The first ligand can be an unsymmetrical amine compound comprising at least two nitrogen.

The first ligand can be, for example, a ligand comprising sulfur, such as tetrahydrothiophene, or an amine. Amine ligands are known in the art. See, for example, Cotton and Wilkinson textbook cited above, page 118. Also, nitrogen heterocycles like pyridine can be used.

The first ligand can be an amine including an alkyl amine. The alkyl groups can be linear, branched, or cyclic. Bridging alkylene can be used to link multiple nitrogen together. In the amine, the number of carbon atoms can be, for example, 15 or less, or ten or less.

The molecular weight of the first ligand, including an amine, can be, for example, about 1,000 g/mol or less, or about 500 g/mol or less, or about 250 g/mol or less.

In one embodiment, the first ligand is not a phosphine. In one embodiment, the first ligand is not tetrahydrothiophene. In one embodiment, the first ligand does not comprise a ligand comprising sulfur.
In one embodiment, the first ligand does not comprise a fluorine-containing ligand.

Examples of the first ligand can be found in the working examples below.

SECOND LIGAND

The second ligand is different from the first ligand and can volatilizes upon heating the metal complex. For example, it can release carbon dioxide, as well as volatile small organic molecules, in some embodiments. The second

ligand can be adapted to volatilize when heated without formation of a solid product. Heating can be done in the presence or absence of oxygen. The second ligand can be a chelators with a minimum number of atoms that can bear an anionic charge and provide a neutral complex. This can make the complex soluble in aromatic hydrocarbon solvent. The second ligand can be anionic. It can be self-reducing.

The second ligand can be a carboxylate, which is known in the art. See, for example, Cotton and Wilkinson textbook cited above, pages 170-172. Carboxylates including silver carboxylates are known in the art. See, for example, US Patent Nos. 7,153,635; 7,445,884; 6,991,894; and 7,524,621.

The second ligand can be a carboxylate comprising a hydrocarbon such as, for example, an alkyl group.

The second ligand can be a carboxylate represented by OOC-R, wherein R is an alkyl group, wherein R has 10 or fewer carbon atoms, or five or fewer carbon atoms. R can be linear, branched, or cyclic. The second ligand can be fluorinated if desired including, for example, comprise trifluoromethyl groups. The second ligand can be a carboxylate but not a fatty acid carboxylate. The second ligand can be an aliphatic carboxylate. The second ligand can be not a formate ligand.

The molecular weight of the second ligand, including the carboxylate, can be, for example, about 1,000 g/mol or less, or about 500 g/mol or less, or about 250 g/mol, or about 150 g/mol or less or less.

In one embodiment, the second ligand does not comprise a fluorine-containing ligand. Examples of the second ligand can be found in the working examples below.

## AN ADDITIONAL DISCLOSURE

In another embodiment, the metal complex can comprise at least two ligands, comprising first and second ligands, and the ligands can be the same or different.

In particular, another embodiment provides a composition comprising at least one metal complex comprising at least one metal and at least two ligands, wherein at least one first ligand is a sigma donor to the metal and volatilizes upon heating the metal complex, and at least one second ligand which also volatilizes upon heating the metal complex. The metal complex can be soluble in a solvent at 25°C.

In one embodiment, the first ligand and the second ligand are the same ligand. In one embodiment, the first ligand and the second ligand are different ligands.

In one embodiment, the metal is copper. In other embodiments, the metal can also be, for example, silver, gold, platinum, or ruthenium.

In one embodiment, the first ligand comprises at least one nitrogen atom and at least two oxygen atoms.

In one embodiment, the first ligand and the second ligand are the same ligand, and the first ligand comprises at least one nitrogen atom and at least two oxygen atoms.

In one embodiment, the first ligand and the second ligand are the same ligand, and wherein the first ligand comprises at least one nitrogen atom and at least two oxygen atoms, as well as at least one fluorine. For example, the fluorine can be part of a trifluoromethyl group.

In one embodiment, the first ligand is a tridentate ligand. In one embodiment, the first ligand is a tridentate Schiff base ligand.

In one embodiment, the first ligand comprises at least one secondary amine group, at least one carbonyl group, and at least one ether group.

See, for example, for this additional disclosure, working example 6 below and the ligand used therein as first and second ligand.

## CHARACTERISTICS OF THE METAL COMPLEXES

The metal complex can have a sharp decomposition transition beginning at a temperature of less than 250°C, or less than 200°C, or less than 150°C, or less than 120°C.

The composition can be stored at about 25°C for at least 100 hours, or at least 250 hours, or at least 500 hours, or at least 1,000 hours, or at least six months, without substantial deposition of metal (0). This storage can be neat or in a solvent. The composition can be stored at lower temperatures such as, for example, less than 25°C to provide longer stability. For example, some composition can be stored at 0°C for very long periods of time including, for example, at least 30 days, or at least 90 days, or at least 365 days. Alternatively, for example, some composition can be stored at -35°C or lower for very long periods of time including, for example, at least 30 days, or at least 90 days, or at least 365 days.

The complexes can comprise, for example, at least 25 wt.% metal, or at least 50 wt.% metal, or at least 60 wt.% metal, or at least 70 wt.% metal. This provides for efficient use of metal and good conductivity upon conversion to metal.

The metal complexes can be adapted to provide sufficient stability to be commercially useful, but also sufficiently reactive to provide low cost, high quality products. One skilled in the art can adapt the first and second ligands to achieve

a balance needed for a particular application.

METHODS OF MAKING COMPOSITIONS

Metal complexes can be made by a variety of methods. Disclosed is a method, wherein metal or silver carboxylate complexes are prepared by reacting the metal or silver carboxylate precursor with an ester so that an exchange reaction occurs to form a new metal or silver carboxylate complex. See, for example, reaction (1) below, wherein R can be, for example, an alkyl group including a linear, branched, or cyclic alkyl, including for example an alkyl group with ten or fewer, or five or fewer carbon atoms. The yield of reaction can be, for example, at least 50%, or at least 70%, or at least 90%. Disclosed is a method, wherein the metal or silver carboxylate complex is made without use of metal oxide including $Ag_2O$. Disclosed is a method, wherein the metal or silver carboxylate is made without use of a solid state reaction. See, for example, comparative example reaction (2) below.
Disclosed is a method, wherein gold complexes are prepared by reaction of a gold chloride complex, which is also complexed with a sigma donor such as tetrahydrothiophene or a phosphine, with a silver carboxylate complex. The result is precipitation of silver chloride. See, for example, reactions (3), (4), and (5) below.
Disclosed is a method, wherein metal complexes are prepared by exchanging dative bonding ligands such as the first ligands. For example, tetrahydrothiophene can be exchanged for an amine.

DEPOSITION OF INK

Methods known in the art can be used to deposit inks including, for example, spin coating, pipetting, inkjet printing, blade coating, rod coating, dip coating, lithography or offset printing, gravure, flexography, screen printing, stencil printing, drop casting, slot die, roll-to-roll, spraying, and stamping. One can adapt the ink formulation and the substrate with the deposition method. See also *Direct Write Technologies* book cited above. For example, chapter 7 describes inkjet printing. Contact and non-contact deposition can be used. Vacuum deposition can be not used. Liquid deposition can be used.
One can adapt the viscosity of the ink to the deposition method. For example, viscosity can be adapted for ink jet printing. Viscosity can be, for example, about 500 Cps or less. Or viscosity can be, for example, 1,000 Cps or more. One can also adapt the concentration of solids in the ink. The concentration of the solids in the ink can be, for example, about 500 mg/mL or less, or about 250 mg/mL or less, or about 100 mg/mL or less, or about 150 mg/mL or less, or about 100 mg/mL or less. A lower amount can be, for example, about 1 mg/mL or more, or about 10 mg/mL or more. Ranges can be formulated with these upper and lower embodiments including, for example, about 1 mg/mL to about 500 mg/mL. In addition, the wetting properties of the ink can be adapted.
Additives such as, for example, surfactants, dispersants, and/or binders can be used to control one or more ink properties if desired. In one embodiment, an additive is not used. In one embodiment, a surfactant is not used.
Nozzles can be used to deposit the precursor, and nozzle diameter can be, for example, less than 100 microns, or less than 50 microns. The absence of particulates can help with prevention of clogging the nozzle.
In deposition, solvent can be removed, and the initial steps for converting metal precursor to metal can be started.

CONVERTING PRECURSOR TO METAL

The inks and compositions comprising metal complexes can be deposited and converted to metallic structures including films and lines. Heat and/or light can be used including laser light. The atmosphere around the metal film can be controlled. For example, oxygen can be included or excluded. Volatile by-products can be eliminated.

METALLIC LINES AFTER DEPOSITION AND CURING

The metallic lines and films can be coherent and continuous. Continuous metallization can be observed with good connectivity between grains and low surface roughness.
Line width can be, for example, 1 micron to 500 microns, or 5 microns to 300 microns. Line width can be less than one micron if nanoscale patterning methods are used.
Dots or circles can be also made.
In one embodiment, ink formulations can be converted to metallic lines and films without formation of substantial amounts of metal particles, microparticles, or nanoparticles.
Metal lines and films can be prepared with characteristics of metal and lines prepared by other methods like sputtering.
Metal lines and films can be, for example, at least 90 wt.% metal, or at least 95 wt.% metal, or at least 98 wt.% metal.

Metal lines and films can be relative smooth according to AFM measurements.

Metal lines and films can be used to join structures such as electrodes or other conductive structures.

The metal can have a work function which is substantially the same as a native metal work function. For example, the difference can be 25% or less, or 10% or less.

Lines and grids can be formed. Multi-layer and multi-component metal features can be prepared.

SUBSTRATES

A wide variety of solid materials can be subjected to deposition of the metal inks. Polymers, plastics, metals, ceramics, glasses, silicon, semiconductors, and other solids can be used. Organic and inorganic substrates can be used. Polyester types of substrates can be used. Paper substrates can be used. Printed circuit boards can be used. Substrates used in applications described herein can be used.

Substrates can comprise electrodes and other structures including conductive or semiconductive structures.

APPLICATIONS

Deposition and patterning by direct-write methods, including inkjet printing, is described in, for example, Pique, Chrisey (Eds.), Direct-Write Technologies for Rapid Prototyping Applications, Sensors, Electronics, and Integrated Power Sources, Academic Press, 2002.

One application is forming semiconductor devices including transistors and field effect transistors. Transistors can comprise organic components including conjugated or conductive polymers.

Applications include electronics, printed electronics, flexible electronics, solar cells, displays, screens, light weight devices, LEDs, OLEDs, organic electronic devices, catalysis, fuel cells, RFID, and biomedical.

The deposited metal can be used as a seed layer for use with, for example, subsequent electroplating.

Other technology applications are described in, for example, "Flexible Electronics" by B.D. Gates, Science, vol 323, March 20, 2009, 1566-1567 including 2D and 3D applications.

Examples of patent literature describing methods and applications include, for example, US patent publications 2008/0305268; 2010/0163810; 2006/0130700; and US Patent Nos. 7,014,979; 7,629,017; 6,951,666; 6,818,783; 6,830,778; 6,036,889; 5,882,722.

WORKING EXAMPLES

Example 1. Silver Complexes

Precursors to both silver and gold complexes were silver carboxylates. For their synthesis, a known method based on $Ag_2O$ (reaction 2) was compared to a cleaner, cheaper method based on silver acetate (reaction 1). These are shown below, and two exemplary R groups are shown. The $Ag_2O$ method relies on a solid state reaction, failed to go to completion, and did not yield analytically pure materials. In contrast, the metathesis reaction between a carboxylic acid and silver acetate went to completion, afforded analytically pure compounds, and proceeded in quantitative yields. The elemental analysis of the two silver complexes from this reaction (1) were C, 24.59; H, 3.72 and C, 24.68; H, 2.56 for the isobutyrate and cyclopropate, respectively. Theoretical values are C, 24.64; H, 3.62 and C, 24.90; H, 2.61 for the isobutyrate and cyclopropate, respectively. Thus, approach (1) is superior to (2).

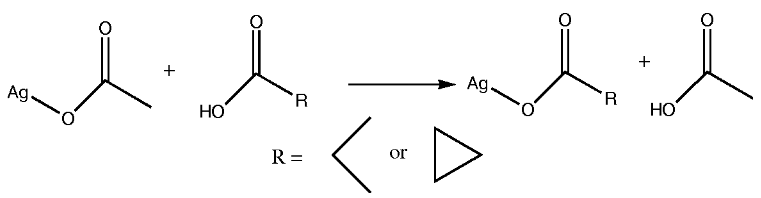
or

(1)

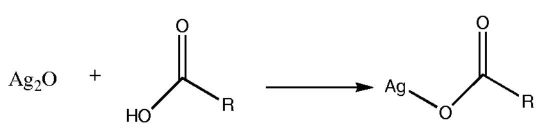

(2)

From the silver complexes, libraries of Ag-carboxylate amine compounds could be prepared that are viable for the production of metallic silver films, lines, and structures (vide infra).

Example 2. Gold Complexes

The carboxylate compounds from Example 1 are also important intermediates in the production of R-Au-carboxylate complexes (gold inks) via the reaction of R-Au-Cl and Ag-carboxylate (R is a dative $\sigma$ donor, or lone pair of electrons). The driving force in this reaction is the formation of a AgCl precipitate, whose low Ksp value and organic insolubility remove it from the reaction equilibrium making the overall yields quite high > 85%.

Examples of gold carboxylate complexes from the reaction of R-Au-Cl and Ag-carboxylate include:

$Ph_3PAuCl + AgOC(O)CH(CH_3)_2 \rightarrow Ph_3PAuOC(O)CH(CH_3)_2 + AgCl$ (reaction 3)

$THTAuCl + AgOC(O)CH(CH_3)_2 \rightarrow THTAuOC(O)CH(CH_3)_2 + AgCl$ (reaction 4)

$THTAuCl + AgOC(O)(C_3H_5) \rightarrow THTAuOC(O)(C_3H_5) + AgCl$ (reaction 5)

Abbreviation legend and structures:

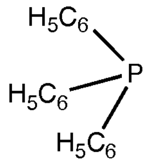

$Ph_3P$

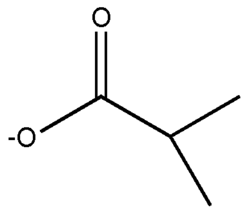

$OC(O)CH(CH_3)_2$

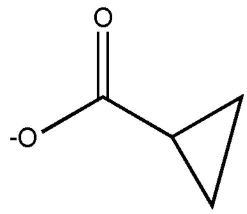

$OC(O)(C_3H_5)$

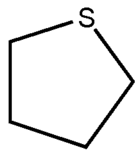

THT

Initially, via this reaction as shown in reaction 3, known and unknown structures of triphenylphosphine gold carboxylate complexes were fabricated, and the crystal structure of one hitherto unknown species is shown in Figure 1. Although these showed excellent solubility in toluene and other aromatic hydrocarbons, they were not preferred to provide uniform films upon thermal treatment as they can result in well-separated gold nanoparticles with less pathway for conduction. This is possibly due to the presence of involatile triphenylphosphine in the starting precursor, which forms involatile triphenylphosphine oxide upon heating to yield an insulating matrix. The AFM (atomic for microscopy) image of these gold nanoparticles is shown in Figure 2.

Example 3. Other Gold Complexes including THT

Following the nanoparticle formation and results with the triphenylphosphine gold carboxylate complexes, a different perspective for the fabrication of Au films was developed. This approach was designed to, for example, (a) maximize metal content in the molecular precursor, (b) use ligands that were volatile while still being able to reduce the Au(I) to Au(0),(c) support the premise that the precursor complex remain soluble in aromatic hydrocarbon solvents, and/or (d) proceed in high overall yields.

Tetrahydrothiophene (THT) gold complexes were investigated. An entryway into this chemistry is, for example, through the reaction of commercially available $HAuCl_4$ and 2 equivalents of THT to yield known THT-Au-Cl. From this molecule, the reaction of a Ag-carboxylate with THT-Au-Cl can proceed with the formation of an insoluble AgCl byproduct, that can be easily filtered off, yielding the desired, unkown THT-Au-carboxylates (reactions (4) and (5), preceeding page). Thus the THT molecule would reduce the Au(I), and the carboxylates would fissure to release $CO_2$ and a small organic radical that would abstract a hydrogen from a solvent.

Shown in Figure 3 is the TGA (thermogravimetric analysis) of the gold complex (inset). On the y-axis is the percent mass loss and on the x-axis is temperature. Based on the theoretical value of approximately 53% gold residue for the proposed structure, one can see that the data is in good agreement with theory. This adds further credence that the postulated structure is indeed the composition of the product from the reaction of THT-Au-Cl and Ag-carboxylate. At this stage it is noteworthy that although the sharp transition begins at about 90°C, the THT-Au-carboxylate complexes slowly plate Au(0) at room temperature and can be stored cold, as neat oils or aromatic hydrocarbon solutions.

After the synthesis of the THT-Au-carboxylates, gold films were deposited using toluene precursor solutions (concentrations varied, but ranged up to 200 mg/mL) and Patch pipettes. As can be seen from the log resistivity versus

temperature plots, complete metallization occurs at and before 110°C. Also, as the solutions age, the onset of metallization begins to decrease slightly in temperature. Alternatively, 100 mg/mL Au solutions have been spin-coated on UV/ozone cleaned glass and $Si/SiO_2$ at 1000-1300 rpm. The AFM images of the Au lines between two electrode pads show continuous metallization with excellent connectivity between the grains and low surface roughnesses. The SEM/EDXS measurements unequivocally show that Au is present and the line is coherent and continuous.

Example 4. Gold Amine Complexes including DEED

Because of the slight thermal instability and decreased longevity of the THT-Au-cyclopropate complex, and partly because silver amine complexes were performing very well, two gold complexes were reacted with N,N-diethylethylenediamine (DEED) (see below). The (THT)Au(carboxylates) were dissolved in toluene, and a large excess of DEED was added. The reaction was allowed to stir overnight, and the solution was filtered and placed under vacuum the next day. Both the cyclopropate and isobutyrate complexes were synthesized by analogous routes and their syntheses are shown below. Both exhibited increased metallization temperatures which suggests greater stability.

1) THT-Au-cyclopropate with DEED

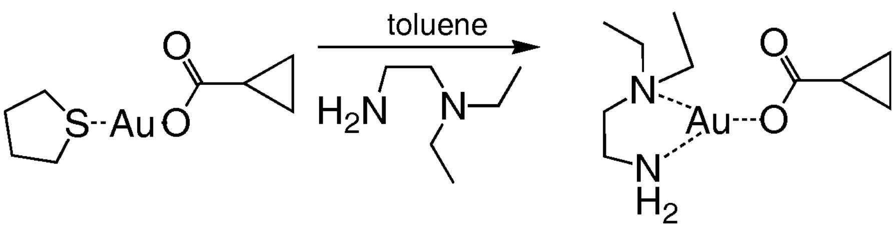


THT-Au-isobutyrate with DEED

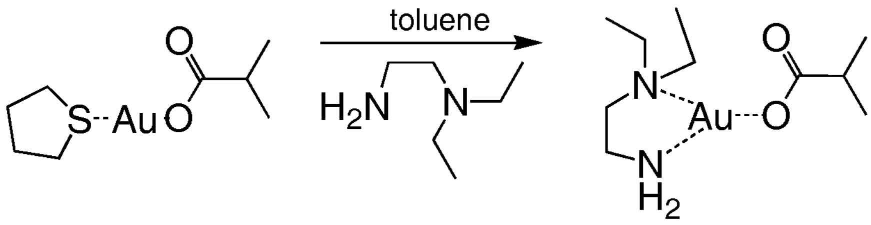


Example 5. Silver Amine Complexes including TMEDA and DEED

The new silver carboxylate compounds, synthesized from either $Ag_2O$ or $AgO_2C_2H_3$ (silver acetate, a new method) vide supra, were reacted neat with different multidentate amines and tested for their viability as conducting ink materials. All reactions were done overnight at room temperature, the solutions were gravity filtered, and the excess amine removed in vacuo. Amine ligands can have ability to act as electron donating species (reductants) to achieve the transformation of Ag(I) to Ag(0). Furthermore, they can afford volatile by-products that would minimize film impurities. The choice of carboxylate as the other ligand was to select chelators with a minimum number of atoms that would bear an anionic charge, making the molecule neutral and thus soluble in aromatic hydrocarbon solvents. It was envisioned that the carboxylate would again fissure to yield $CO_2$ (a gas) and volatile small organic molecules.

The reaction between silver cyclopropionate and N,N,N',N'-tetramethylethylenediamine (TMEDA) was attempted. Although successful, the product was a dinuclear silver complex with argentophilic interactions, intramolecular bridging carboxylates, and intermolecular bridging TMEDAs. After recrystallization from TMEDA, and despite the high metal content, the complex was found to be insoluble in toluene and hygroscopic.

1.) Synthesis of silver (I) cyclopropate with N,N,N',N'-tetramethylethylenediamine (TMEDA)

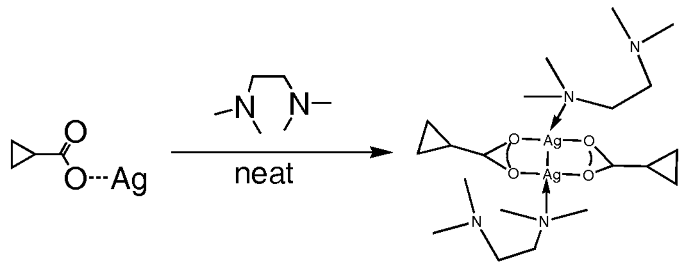


Figure 4 shows a diffraction-derived molecular structure of dinuclear complex from above reaction

Two drawbacks of the silver TMEDA system were solubility and moisture sensitivity. It was postulated that the solubility issue could be remedied by using an unsymmetrical, bidentate amine with longer alkyl chains on an N-terminus and a non-cyclic carboxylate, which could not pack effectively in the solid state. Concerning the latter, it was believed that the moisture sensitivity may be rooted in the weak argentophilic interation (Ag-Ag bond) that would hydrolyze upon exposure to moisture under ambient conditions to place a $H_2O$ molecule in the Ag coordination sphere. Thus, silver isobutyrate was used as one starting material and N,N-diethylethylenediamine (DEED) as the other reactant to hopefully yield more coordinately saturated, soluble, non-hygroscopic mononuclear molecules without Ag-Ag bonds.

2) Synthesis of silver (I) isobutyrate with N,N-diethylethylenediamine (DEED)

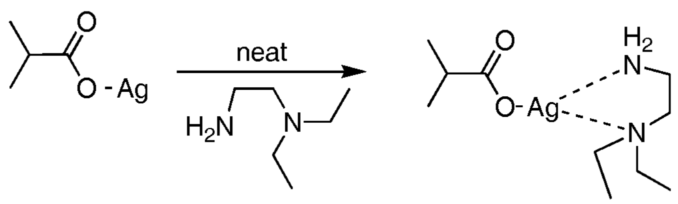


Figure 5 shows a diffraction-derived molecular structure of mononulear complex from above reaction.

As can be seen from the single crystal x-ray structure (above), a mononuclear Ag(I) complex was synthesized containing a carboxylate and an unsymmetrical bidentate amine bearing N,N-diethyls. The coordination geometry about the silver ion is trigonal planar with both amine nitrogen bound and a single oxygen atom of the carboxylate coordinated. This complex is not moisture sensitive and is soluble in aromatic hydrocarbons such as toluene and xylenes. Thus, it provides a number of advantages.

Following the successful synthesis of the above compound, toluene solutions of 65-75 mg/mL concentrations were made, and lines were drawn between two gold electrode pads and annealed under ambient conditions. The change in resistivity was measured as a function of temperature, and the resulting metal was preliminarily characterized. Toward this goal the following data were obtained. Figure 6 is the change in log resistivity (y-axis) versus temperature (°C, x-axis). From this data, it is apparent that a striking loss (about 7 orders of magnitude) of resistivity occurs between 190 and 210°C. To test the composition and morphology of the resulting silver, scanning electron microscopy (SEM) and energy dispersive x-ray spectroscopy (EDXS) were performed. The former visualizes the material under high magnification, while the latter gives information about the elemental composition. The SEM image clearly shows silver metal adhering to the gold electrode. EDXS indicates that four elements are present Ag, Si, O, and C. The Si and O arise from the substrate and should not be considered, whereas the Ag and C are relevant. The carbon is most likely surface bound contamination. The resulting Ag(O) is metallic.

Figure 6 shows log resistivity versus temperature graph. Figure 7 shows SEM, and Figure 8 shows EDXS of the metallic silver deposited from the above Ag(I) complex. The EDXS data showed that only C, Si, O and Ag are present in the film, with Si and O originating from the substrate.

The solution deposition from a Patch pipette (above) was the initial method used to deposit the Ag ink. However this only served as a preliminary experiment prior to the inkjet deposition of silver lines using a 62.5mg/mL toluene ink. As can be seen in Figure 9, inkjet deposition was successful using a 30 $\mu$m nozzle to afford approximately 200 $\mu$m width

lines.

Given the success of the (DEED)Ag(isobutyrate), carboxylates were changed and the cyclopropate anion as a coordinating ligand was explored.

It was initially somewhat surprising that this complex metallized at a slightly higher temperature than the analogous (DEED)Ag(isobutyrate). However, while the present inventions are not limited by scientific theory, the rationale may be uncovered by the crystalline packing of silver (I) cyclopropate with N,N,N',N'-tetramethylethylenediamine (TMEDA). In this structure, the cyclopropyl groups stack atop each other, stabilizing the molecular structure and similar behavior could be envisioned here. Following evaporation of the solvent, this molecule may align using the cyclopropyl groups as a zipper, thereby thermally stabilizing the resulting film yielding higher metallization temperatures.

Silver (I) cyclopropate with DEED

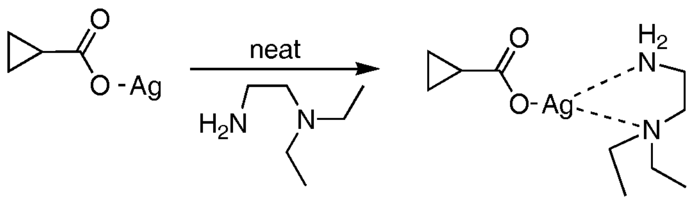


Figure 10 is the log resistivity versus temperature plot of a (DEED)Ag(cyclopropate) line drawn between two gold electrode pads on $Si/SiO_2$ from a 65 mg/mL toluene solution. As exhibited in this figure, one again sees an about 7 fold drop in resisitivity over an approximately 50°C range starting at about 190°C. It is interesting that metallization occurs at a higher temperature, suggesting greater stability, which is what would be desirable in a product with significant shelf-life and longevity.

Concerning the silver, a tridentate amine (N,N,N',N',N''-pentamethyldiethylenetriamine (PMDETA), synthesis below) was employed as a coordinating ligand. As drawn, the tridentate amine is coordinated through all of its nitrogen donor atoms to yields a four coordinate complex. In Figure 11 is again a log resistivity versus temperature plot of a (PMDEA)Ag(isobutyrate) line drawn between two gold electrode pads on $Si/SiO_2$ from a 65mg/mL toluene solution. As can be seen this complex undergoes metallization at an even higher temperature than the previous two silver complexes with a nearly identical, 7 fold change in resistivity. This is most likely due to two factors. First, a four coordinate Ag(I) is less labile and mobile than a three coordinate cation, and second, the tridentate amine has a much higher boiling point than the bidentate amines making it less volatile and less apt to decompose to base metal.

1) Silver (I) cyclopropate with N,N,N',N',N''-pentamethyldiethylenetriamine (PMDETA)

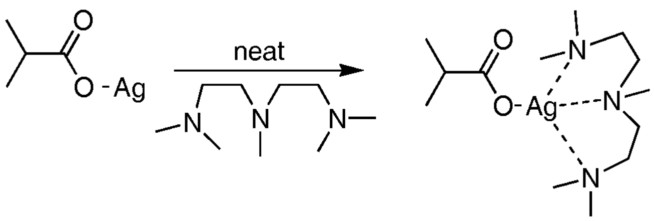


Example 6. Copper Complex

A tridentate Schiff base ligand was synthesized by reaction of a partially fluorinated acetoacetone derivative with ethanolamine. The tridentate Schiff base was purified by recrystallization to yield about 50% product. This ligand was then reacted with copper methoxide, $Cu(OMe)_2$ in benzene and refluxed overnight. A log resistivity versus temperature plot is also shown (Figure 12) indicating an approximate drop in resistivity of 4 orders of magnitude suggestive of the formation of copper metal. SEM/EDXS (Figures 13 and 14), between two gold electrode pads, confirms the presence of three elements, Cu, Si, and O. The Si and O both arrive from the substrate, whereas the copper comes from thermal decomposition of the complex.

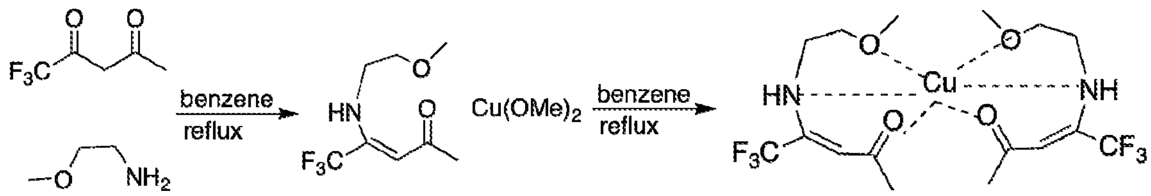


Example 7. Additional Structural Information

Given the success of the (DEED)Ag(isobutyrate), the cyclopropate anion was used as a coordinating ligand. As can be seen from the diffraction-derived molecular structure (Figure 15), this mononuclear complex contains the bidentate amine and the cyclopropyl carboxylate. The geometry about the four-coordinate $Ag^{1+}$ ion is tetrahedral with both amine nitrogen atoms bound as well as both oxygen atoms from the carboxylate. In contrast, only one carboxylate oxygen was bonded in the aforementioned, previously shown, (DEED)Ag(isobutyrate). The different thermal behavior (higher metallization temperatures) of this compound with two Ag-O interactions suggests that these (among packing factors, vide infra) may be responsible for the increased stability.

Example 8. Additional Embodiments including XPS and Work Function

Atomic Force Microscopy (AFM): An AFM image showed the presence of a Au(0) film deposited (spin cast, 1300 rpm from 100 mg/mL toluene solution) onto a glass substrate. As evidenced from this 25 $\mu m^2$ image, the height ranged from approximately 40 to 60 nm with a low rms surface roughness of 7.90 nm. The film was uniform without pinholes, defects, or nanoparticles and these observations were substantially continuous throughout the sampled areas. Following AFM measurements, the electrical properties of the sample were interrogated, and these are subsequently described (vide infra).

Electrical Conductivity Measurements: Electrical conductivity measurements were performed on thin films derived from (THT)Au-cyclopropate by the standard spring-loaded pressure-contact four-point probe method at ambient conditions. Films were formed from toluene solutions spun-cast at 1000-1300 rpm. Film metallization was then achieved by heating on a hotplate for about 1 minute to a temperature of about 150°C. This method led to Au films with thicknesses ranging from 20-50 nm. Conductivity was measured using a four-point probe station. Film thickness was measured by AFM on the punctures in the films made by the probes. Conductivity [$S \cdot cm^{-1}$] was calculated according to the following equation:

$$\sigma = \frac{1}{4.53 \times R \times l} \qquad (1)$$

where R is the resistance (R = *V*/*I*) in and *l* is the film thickness in cm. It was found that the Au formed from the spun-cast metal inks gave conductivities on the average of about 4 x $10^6$ S $cm^{-1}$, which is just one magnitude lower than what was observed with sputtered Au samples.

X-ray photoelectron spectroscopy (XPS) and Ultraviolet Photoelectron Spectroscopy (UPS): The interface was examined using XPS and UPS measurements.

*Sample Preparation*

The starting substrate was a highly doped (n+) Si wafer (1.5 X 1.5 $inch^2$). The wafers were etched with buffered oxide etchant (BOE) in a class 100 clean-room at Carnegie Mellon University to remove the native oxide layer. Thereafter, the final samples were prepared as follows:

Sputtered Au film: 5 nm of Ti (adhesion layer) and 50 nm of Au were sputtered onto the doped n+ Si wafer.
Au thin film from metal precursor solution: The n+ Si wafer was cleaned at 120°C in an UV-$O_3$ plasma cleaner for 20 minutes. The wafer was then placed on a hot plate initially at room temperature. Thereafter the Au precursor solution was dropped onto the wafer as a 100 mg/mL toluene solution. The temperature was then increased to ~ 150 °C to evaporate the solvent and form the metal film.

*XPS and UPS measurements*

The measurements were conducted using a scanning multiprobe surface analysis system-Phi 5000 Versaprobe. This system comprises a monochromatic focused Al Kα X-ray (1486.7 eV) source, a He source and a hemispherical analyzer.

XPS settings: The X-ray beam was incident normal to the sample unless specified, and the emitted photoelectrons were collected at an emission angle of 45° relative to the sample normal. Wide scan data were collected using pass energy of 117.4 eV. High-resolution scans were obtained using pass energy of 23.5 eV. The XPS spectra were referenced to an energy scale with binding energies for Cu $2p_{3/2}$ at 932.67 ± 0.05 eV and Au 4f at 84.0 ± 0.05 eV. The sputter cleaning of the samples were carried out using 2 kV Ar+ sputtering over a 3 mm × 3 mm area of the specimen. The sputter rate for 2 kV $Ar^+$ over a 3 mm X 3 mm raster area is determined to be 6.5 nm/min, using $SiO_2$/Si reference material with known thickness from X-ray reflectivity and ellipsometry.

UPS setting: UPS measurements were conducted using the He I (*hv*=21.2eV) line. The pass-energy used was 0.585eV. During UPS measurements -5 V bias was applied to the sample in order to separate sample and analyzer high binding energy cutoffs.

The XPS and UPS spectra were processed using the CasaXPS software licensed by PNNL (Pacific Northwest National Laboratory). Work function values were determined from the UPS spectra by linear fit of the high and low binding energy cutoffs (secondary cut-off edge and Fermi-edge respectively) of the spectra and determination of their intersections with the binding energy axis.

*XPS Results*

XPS is a surface science technique whose penetration depth (the sampling depth from the vacuum level at the sample top) is about 50 to 65 Å. It is capable of exploring the atomic compositions of thin films as well as their neighboring atoms, oxidation states, and relative abundance. For each and every element, there will be a characteristic binding energy associated with each core atomic orbital i.e. each element will give rise to a characteristic set of peaks in the x-ray photoelectron spectrum at kinetic energies determined by the photon energy and the respective binding energies.

The presence of peaks at particular energies therefore indicates the presence of a specific element in the sample under study - furthermore, the intensity of the peaks is related to the concentration of the element within the sampled region. Thus, the technique provides a quantitative analysis of the surface composition.

In gold films deposited from solution, 100 mg/mL toluene solutions drop cast on a n-doped Si square and heated to about 150°C, four elements are observed - Au, Ag, C, and O. The adventitious Ag is an expected result of the Au precursor synthesis (vide supra) and can be removed by further filtering of the precursor solution or centrifugation of the reaction followed again by filtering. However, in this sample its presence was constant throughout the film. The C and O can result from either surface contamination (commonly seen in XPS from handling the sample under ambient conditions before load-locking into the ultrahigh vacuum chamber) or from incomplete thermal decomposition of the precursor solution. Via sputtering experiments, these light elements most likely originate from the former method of contamination. As can be seen (Figure 16) from depth profiling XPS spectra (sputtered with $Ar^+$ which slowly ablates the surface, hence the term "depth profiling") the Au and Ag peaks remain constant (the Au actually increases as the C and O are removed by the impinging $Ar^+$ ions) whereas the C and O peaks significantly decrease or disappear, respectively. The elemental compositions of a film sputtered for four minutes (in our hands the maximum time for which the experiments were undertaken) are as follows: Au (70.3%), Ag (5.8%), C (17.9%), and O (5.9%). The binding energy position of the Au 4f peak unequivocally shows that gold is in the zero oxidation state and as such can be considered metallic (further confirmed by UPS). Based on the peak positions of the C and O atoms, these are most likely bonded to each other and most likely exist as either carbonates or carboxylates, again resulting from either spurious atmospheric contamination or incomplete combustion of the precursors in air.

An important piece of data is the UPS spectrum (Figure 17). UPS is an extremely surface sensitive technique that explores the outermost 1-2 unit cells (10 Å) of sample. From this spectrum, one can determine that the Au film is indeed metallic and behaves as a metal with respect to incoming photons. It also allows one to calculate the gold work function $(\phi)_{Au}$) based on differences between the Fermi level energy ($E_F$) and the cut-off energy ($E_{CO}$). Based on this calculation, $\phi_{Au}$ was determined from the film derived from a precursor solution to be 4.9 eV. For a sputtered gold sample, our standard comparison, the $\phi_{Au}$ is 4.7 eV. This means that the gold system described herein is compatible with the semiconducting organic polymers using to fabricate thin film transistors.

Example 9. Additional Examples, Structural Information, Silver Thioether

It has been theorized that sulfur compounds can act as a better reductant when compared to nitrogen. As such, a sulfur-compound with enough side chains to ensure solubility was sought. A commercially available compound, 3,6-dithiaoctane was found, with the synthesis also readily available in literature. As such the dithioether **(B)** is not a new compound. Silver isobutyrate, described in a previous section, was reacted with 3,6-dithiaoctane in toluene and refluxed overnight. The solution was then filtered and the solvent was removed with vacuum. The remaining yellow solid was then examined for its chemical composition and its ability to form Ag(0) metal.

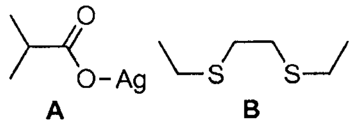

**A** **B**

Crystals were grown, sent for analysis and the diffraction-derived structure was obtained shown in Figure 18. Notice the argentophilic interactions (i.e., dimerization of the silver centers) as well as the intermolecular bridging sulfur ligands. This structure may be quite similar to the initial silver TMEDA complex previously communicated. However, this silver thioether complex is quite soluble in aromatic organic solvents. Using a 100 mg/mL toluene solution of the metal complex and a Patch pipette, lines were drawn between two gold electrode pads, annealed under ambient conditions, and a preliminary analysis of thermal stability was measured. Looking at the change in resistivity as a function of temperature (Figure 19), it can be seen that the silver thioether complex decomposes into base metal at about 100°C, which is a *much lower* temperature when compared to all of the silver amine complexes (> 100°C). This lower metallization temperature is attributed to the stronger reducing power of the thioether compared to amine ligands.

Figure 19 shows Log resistivity vs. temperature graph, and Figure 20 shows drawn silver line between gold electrodes after metallization.

The metal complex was also quite stable, both in solution and in crystalline form. As a solid, it can be stored in a refrigerator for weeks, perhaps or most likely indefinitely, with seemingly no or little change in its appearance or properties. In solution, it recrystallized after some time, but can be readily re-dissolved in a warm water bath and used again.

In summary, the synthesis and characterization of a new silver thioether complex is shown, its crystal structure presented, and it was used to deposit silver metal. The use of sulfur containing ligands represents a departure from our previous efforts on nitrogenous ligands, and because of its superior reducing power affords lower metallization temperatures.

Example 10. Dimethylthioether

Although the THT-Au-carboxylate complexes showed promising metalizations results leading to metallic gold at low temperatures (90 - 100°C) their thermal stability was slightly less than desirable as they had to be stored at -35°C, at which temperature they are indefinitely stable. This may be the result of the low steric encumberances afforded by the THT ligand, whose methylene groups alpha to the sulfur atom were pinned back by an ethane bridge. To address this shortcoming, it was sought to increase the thioether sterics about the

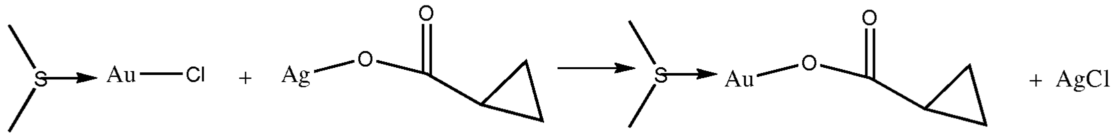

gold ion by using a dimethylthioether (or dimethyl sulfide) ligand. This also removes two carbon and four hydrogen atoms compared to the THT ligand thereby increasing the metal content available for metallization. The synthesis is shown above. The reaction was performed with overnight stirring at room temperature in toluene using commercially available $C_2H_6SAuCl$. Its driving force is formation of the insoluble AgCl precipitate that is removed by simple gravity filtration. This rationale proved to be correct, as the increased steric bulk about the Au atom imparts greater stability and this complex is indefinitely stable at 0°C. Surprisingly it metalizes at a similar temperature as the THT-Au-carboxylates and affords high quality gold films with exceptional conductivities.

This complex crystallized from toluene solutions, and a suitable crystal for x-ray diffraction was identified. The diffraction-derived molecular structure exhibits 3 independent Au atoms with both terminal and bridging sulfurs as well as singly bound carboxylates. There are formal aurophilic interactions between the gold atoms. The derived molecular structure is shown in Figure 29.

Example 11. Additional Examples.

Figure 21 illustrates additional aspects for the synthesis of metal complexes. The only required purification step is a simple filtration. The reactions proceed in high yield and analytical purity. The compounds are stable toward air and moisture. The final product should be stored cold to reduce gold formation.
Figure 22 shows a microcapillary approach controlled initially by a micromanipulator arm, and then a final approach by piezo stack.
Figure 23 shows impact of aging on resistivity versus temperature plots.
Figure 24 shows a drawn gold line and gold pads.
Figure 25 shows EDX data showing high content of gold.
Figure 26 shows an experiment for ink jet printing of gold line, with 10 mg THTAuCyclopropanate/1 mL dry xylenes solution, 5 mm/sec travel time, 1 drop/0.04 mm, with 30 micron printhead aperture on $SiO_2$.
Figure 27 shows XPS of gold peaks comparing precursor solution approach versus sputtering approach.
Figure 28 provides additional conductivity and resistivity data, as well as an AFM image, for a gold film.

## Claims

1. A composition comprising at least one metal complex comprising at least one metal and at least two ligands, wherein the metal is silver, wherein at least one first ligand is a sigma donor to the metal and volatilizes upon heating the metal complex, wherein the first ligand is an amine compound comprising at least two nitrogen, and at least one second ligand different from the first which also volatilizes upon heating the metal complex, wherein the second ligand is an isobutyrate ligand, wherein the metal complex is soluble in a solvent at 25°C and wherein the metal complex comprises at least 25 wt.% metal.

2. The composition of claim 1,
wherein the metal complex comprises only one metal center, or
wherein the metal is in an oxidation state of (I) or (II).

3. The composition of claim 1, wherein the first ligand is a monodentate ligand, or wherein the first ligand is a bidentate ligand, or
wherein the first ligand is a tridentate ligand, or
wherein the first ligand is an unsymmetrical amine compound comprising at least two nitrogen.

4. The composition of claim 1, wherein the composition is substantially free of nanoparticles, or
wherein the composition is totally free of nanoparticles, or
wherein the composition has a sharp decomposition transition beginning at a temperature of less than 200°C, or
wherein the composition has a sharp decomposition transition beginning at a temperature of less than 150°C, or
wherein the composition can be stored at about 25°C for at least 100 hours without substantial deposition of metal (0), or
wherein the composition further comprises at least one solvent for the complex, or wherein the composition further comprises at least one aromatic hydrocarbon solvent, or
wherein the composition further comprises at least one solvent, and the concentration of the complex is about 200 mg/mL or less.

5. The composition of claim 1, wherein the solvent is an aromatic hydrocarbon solvent.

6. The composition of claim 1, wherein the metal complex comprises at least 50 wt.% metal, or
wherein the metal complex comprises at least 70 wt.% metal.

7. A method comprising:

   depositing an ink on a surface, wherein the ink comprises a composition according to any one of claims 1-6, and producing a conductive metal film by heating or irradiating said ink.

8. The method of claim 7,
wherein the ink is substantially free of nanoparticles before deposition, or
wherein the ink is substantially free of nanoparticles after deposition.

9. The method of claim 7, wherein the depositing is carried out by inkjet deposition.

10. The method of claim 7, wherein the producing is carried out by heating at a temperature of about 250°C or less, or wherein the producing is carried out by heating at a temperature of about 200°C or less, or wherein the producing is carried out by heating at a temperature of about 150°C or less.

11. The method of claim 7, wherein the film is in the form of a line, and the line has a conductivity of at least 1,000 S/cm, or wherein the film is in the form of a line, and the line has a conductivity of at least 5,000 S/cm, or wherein the film is in the form of a line, and the line has a conductivity of at least 10,000 S/cm, or wherein the film is in the form of a line, and the line has a work function which is within 25 percent of the work function of the pure metal, or wherein the film is in the form of a line, and the line has a work function which is within 10 percent of the work function of the pure metal, or wherein the film is in the form of a line, and the line has a work function which is within 5 percent of the work function of the pure metal.

**Patentansprüche**

1. Zusammensetzung umfassend mindestens einen Metallkomplex, umfassend mindestens ein Metall und mindestens zwei Liganden, wobei das Metall Silber ist, wobei mindestens ein erster Ligand ein Sigma-Donor zu dem Metall ist und sich nach Erhitzen des Metallkomplexes verflüchtigt, wobei der erste Ligand eine Aminverbindung ist, umfassend mindestens zwei Stickstoffe, und mindestens ein zweiter Ligand, der von dem ersten verschieden ist, der auch nach Erhitzen des Metallkomplexes sich verflüchtigt, wobei der zweite Ligand ein Isobutyrat-Ligand ist, wobei der Metallkomplex in einem Lösungsmittel bei 25 °C löslich ist und wobei der Metallkomplex mindestens 25 Gew.-% Metall umfasst.

2. Zusammensetzung nach Anspruch 1, wobei der Metallkomplex nur ein Metallzentrum umfasst, oder wobei das Metall in einem Oxidationszustand von (I) oder (II) ist.

3. Zusammensetzung nach Anspruch 1, wobei der erste Ligand ein einzähniger Ligand ist, oder wobei der erste Ligand ein zweizähniger Ligand ist, oder wobei der erste Ligand ein dreizähniger Ligand ist, oder wobei der erste Ligand eine asymmetrische Aminverbindung ist, umfassend mindestens zwei Stickstoffe.

4. Zusammensetzung nach Anspruch 1, wobei die Zusammensetzung im Wesentlichen frei von Nanopartikeln ist, oder wobei die Zusammensetzung vollständig frei von Nanopartikeln ist, oder wobei die Zusammensetzung einen scharfen Zersetzungsübergang beginnend bei einer Temperatur von weniger als 200 °C hat, oder wobei die Zusammensetzung einen scharfen Zersetzungsübergang beginnend bei einer Temperatur von weniger als 150 °C hat, oder wobei die Zusammensetzung bei ungefähr 25 °C für mindestens 100 Stunden ohne wesentliche Abscheidung von Metall (0) gelagert werden kann, oder wobei die Zusammensetzung ferner mindestens ein Lösungsmittel für den Komplex umfasst, oder wobei die Zusammensetzung ferner mindestens ein aromatisches Kohlenwasserstofflösungsmittel umfasst, oder wobei die Zusammensetzung ferner mindestens ein Lösungsmittel umfasst, und die Konzentration des Komplexes ungefähr 200 mg/ml oder weniger ist.

5. Zusammensetzung nach Anspruch 1, wobei das Lösungsmittel ein aromatisches Kohlenwasserstofflösungsmittel ist.

6. Zusammensetzung nach Anspruch 1, wobei der Metallkomplex mindestens 50 Gew.-% Metall umfasst, oder wobei der Metallkomplex mindestens 70 Gew.-% Metall umfasst.

7. Verfahren umfassend:

   Abscheiden einer Tinte auf einer Oberfläche, wobei die Tinte eine Zusammensetzung gemäß irgendeinem der Ansprüche 1-6 umfasst, und Herstellen eines leitfähigen Metallfilms durch Erhitzen oder Bestrahlen der Tinte.

8. Verfahren nach Anspruch 7,

wobei die Tinte im Wesentlichen frei von Nanopartikeln vor der Abscheidung ist, oder
wobei die Tinte im Wesentlichen frei von Nanopartikeln nach der Abscheidung ist.

**9.** Verfahren nach Anspruch 7, wobei das Abscheiden durch Tintenstrahlabscheidung durchgeführt wird.

**10.** Verfahren nach Anspruch 7, wobei die Herstellung durch Erhitzen bei einer Temperatur von ungefähr 250 °C oder weniger durchgeführt wird, oder wobei die Herstellung durch Erhitzen bei einer Temperatur von ungefähr 200 °C oder weniger durchgeführt wird, oder
wobei die Herstellung durch Erhitzen bei einer Temperatur von ungefähr 150 °C oder weniger durchgeführt wird.

**11.** Verfahren nach Anspruch 7, wobei der Film in der Form einer Linie ist und
die Linie eine Leitfähigkeit von mindestens 1000 S/cm hat, oder
wobei der Film in der Form einer Linie ist und die Linie eine Leitfähigkeit von mindestens 5000 S/cm hat, oder
wobei der Film in der Form einer Linie ist und die Linie eine Leitfähigkeit von mindestens 10000 S/cm hat, oder
wobei der Film in der Form einer Linie ist und die Linie eine Austrittsarbeit (*work function*) hat, die innerhalb von 25 % der Austrittsarbeit des reinen Metalls ist, oder
wobei der Film in der Form einer Linie ist und die Linie eine Austrittsarbeit hat, die innerhalb von 10 % der Austrittsarbeit des reinen Metalls ist, oder wobei der Film in der Form einer Linie ist und die Linie eine Austrittsarbeit hat, die innerhalb von 5 % der Austrittsarbeit des reinen Metalls ist.

## Revendications

**1.** Composition comprenant au moins un complexe métallique qui comprend au moins un métal et au moins deux ligands, où le métal est l'argent, où au moins un premier ligand est un donneur sigma au métal et se volatilise lors du chauffage du complexe métallique, où le premier ligand est un composé amine comprenant au moins deux atomes d'azote, et au moins un deuxième ligand différent du premier qui se volatilise également lors du chauffage du complexe métallique, où le deuxième ligand est un ligand isobutyrate, où le complexe métallique est soluble dans un solvant à 25°C et où le complexe métallique comprend au moins 25 % en poids de métal.

**2.** Composition de la revendication 1,
dans laquelle le complexe métallique ne comprend qu'un centre métallique, ou
dans laquelle le métal est dans un état d'oxydation de (I) ou (II).

**3.** Composition de la revendication 1, dans laquelle le premier ligand est un ligand monodentate, ou
dans laquelle le premier ligand est un ligand bidentate, ou
dans laquelle le premier ligand est un ligand tridentate, ou
dans laquelle le premier ligand est un composé amine asymétrique comprenant au moins deux atomes d'azote.

**4.** Composition de la revendication 1, la composition étant essentiellement exempte de nanoparticules, ou
la composition étant totalement exempte de nanoparticules, ou
la composition ayant une transition brusque vers la décomposition commençant à une température inférieure à 200°C, ou
la composition ayant une transition brusque vers la décomposition commençant à une température inférieure à 150°C, ou
la composition pouvant être stockée à environ 25°C pendant au moins 100 heures sans dépôt substantiel de métal (0), ou
la composition comprenant en outre au moins un solvant pour le complexe, ou
la composition comprenant en outre au moins un solvant hydrocarboné aromatique, ou
la composition comprenant en outre au moins un solvant, et la concentration du complexe étant inférieure ou égale à environ 200 mg/ml.

**5.** Composition de la revendication 1, dans laquelle le solvant est un solvant hydrocarboné aromatique.

**6.** Composition de la revendication 1, dans laquelle le complexe métallique comprend au moins 50 % en poids de métal, ou
dans laquelle le complexe métallique comprend au moins 70 % en poids de métal.

**7.** Procédé comprenant le fait :

de déposer une encre sur une surface, où l'encre comprend une composition selon l'une quelconque des revendications 1 à 6, et
de produire un film métallique conducteur par chauffage ou irradiation de ladite encre.

**8.** Procédé de la revendication 7,
dans lequel l'encre est essentiellement exempte de nanoparticules avant le dépôt, ou
dans lequel l'encre est essentiellement exempte de nanoparticules après le dépôt.

**9.** Procédé de la revendication 7, dans lequel le dépôt est réalisé par dépôt par jet d'encre.

**10.** Procédé de la revendication 7, dans lequel la production est réalisée par chauffage à une température inférieure ou égale à environ 250°C, ou
dans lequel la production est réalisée par chauffage à une température inférieure ou égale à environ 200°C, ou
dans lequel la production est réalisée par chauffage à une température inférieure ou égale à environ 150°C.

**11.** Procédé de la revendication 7, dans lequel le film est sous forme d'une ligne, et la ligne a une conductivité d'au moins 1000 S/cm, ou
dans lequel le film est sous forme d'une ligne, et la ligne a une conductivité d'au moins 5000 S/cm, ou
dans lequel le film est sous forme d'une ligne, et la ligne a une conductivité d'au moins 10000 S/cm, ou
dans lequel le film est sous forme d'une ligne, et la ligne a un travail d'extraction qui est dans les 25 pour cent du travail d'extraction du métal pur, ou
dans lequel le film est sous forme d'une ligne, et la ligne a un travail d'extraction qui est dans les 10 pour cent du travail d'extraction du métal pur, ou
dans lequel le film est sous forme d'une ligne, et la ligne a un travail d'extraction qui est dans les 5 pour cent du travail d'extraction du métal pur.

FIGURE 1

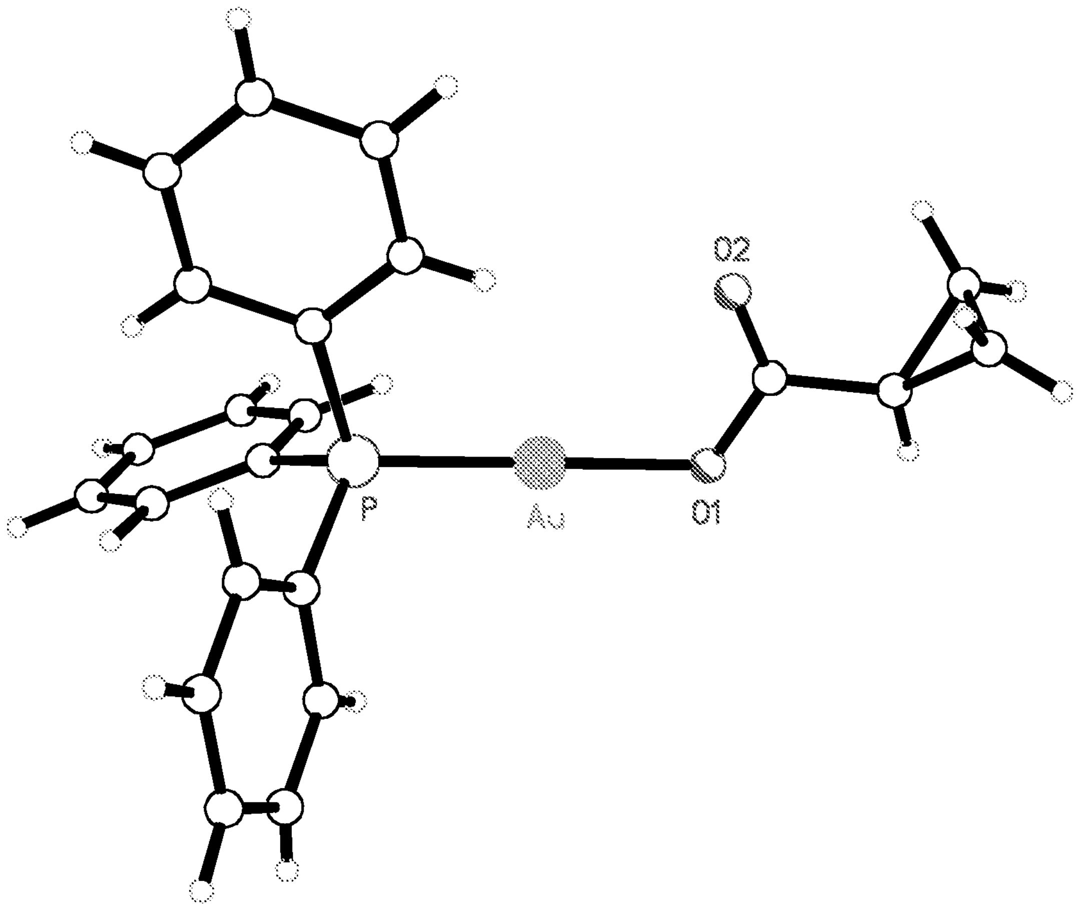

**FIGURE 2**

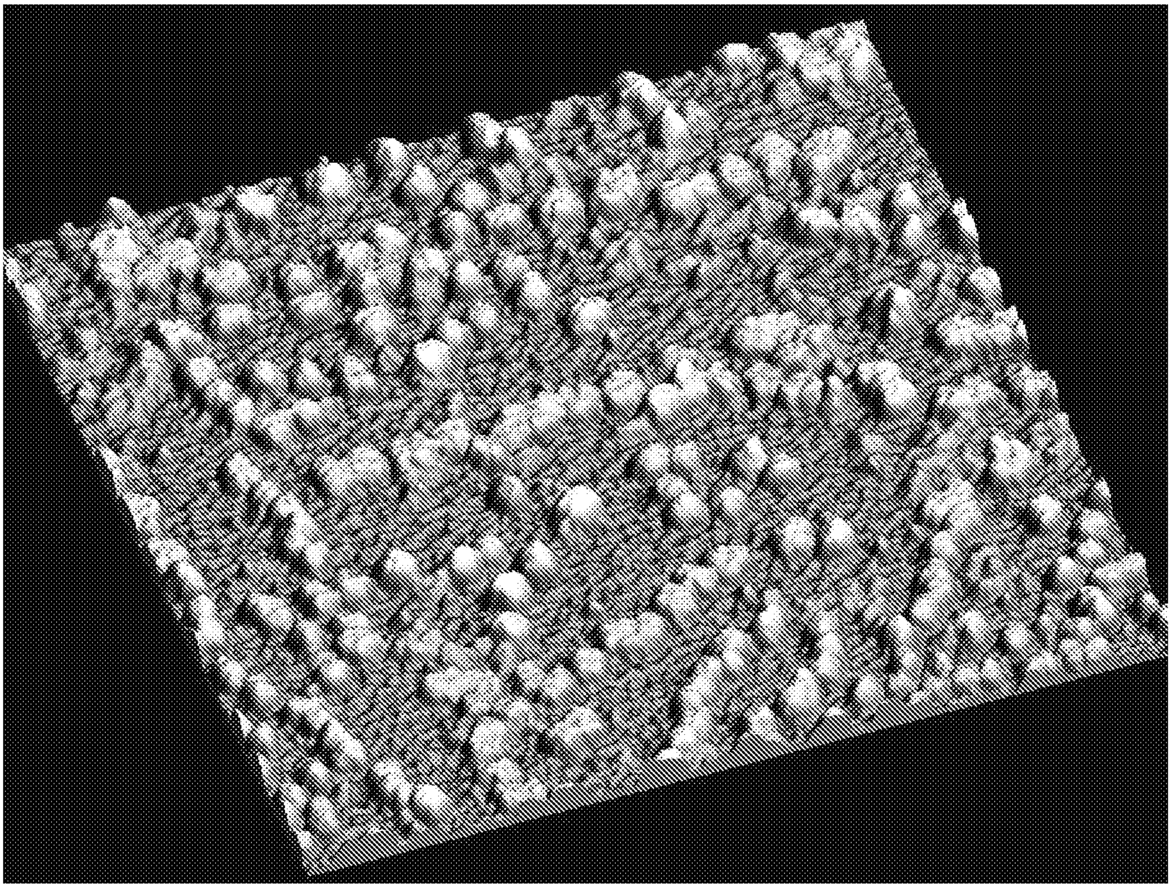

FIGURE 3

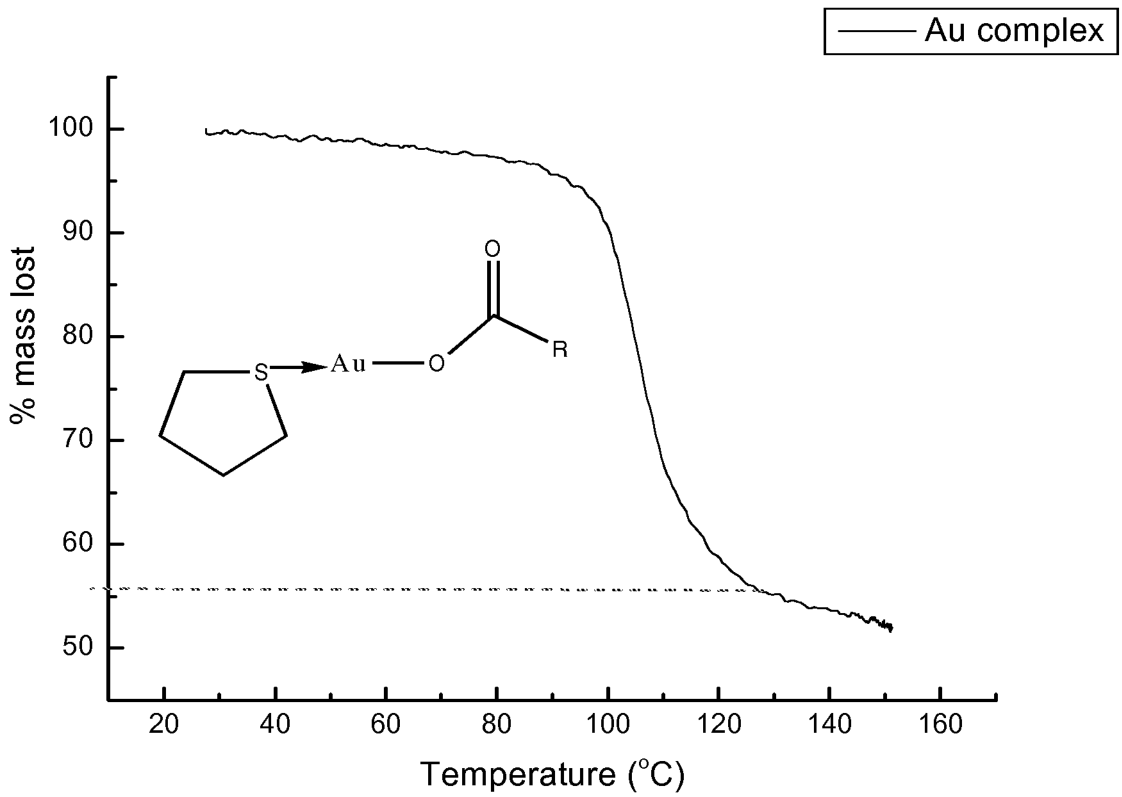
Au complex
% mass lost
100
90
80
70
60
50
20
40
60
80
100
120
140
160
Temperature (°C)

**FIGURE 4**

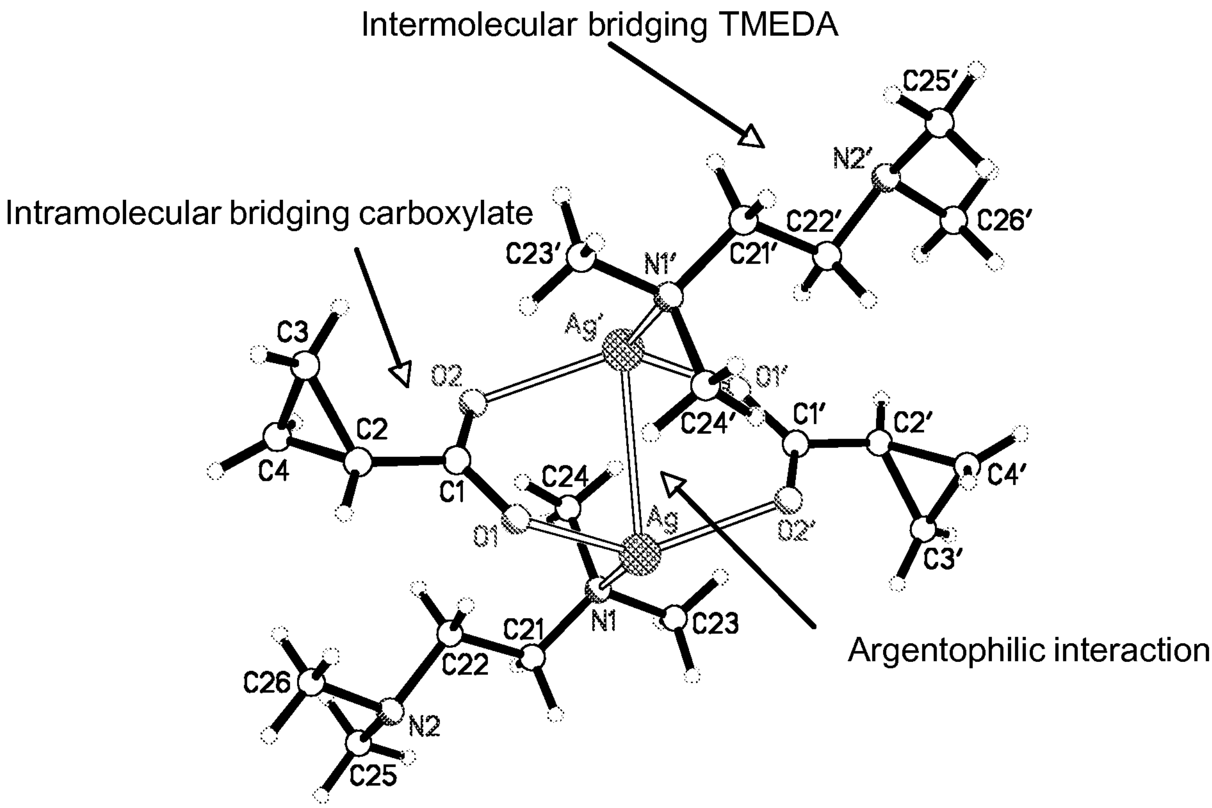
Intermolecular bridging TMEDA
Intramolecular bridging carboxylate
Argentophilic interaction

FIGURE 5

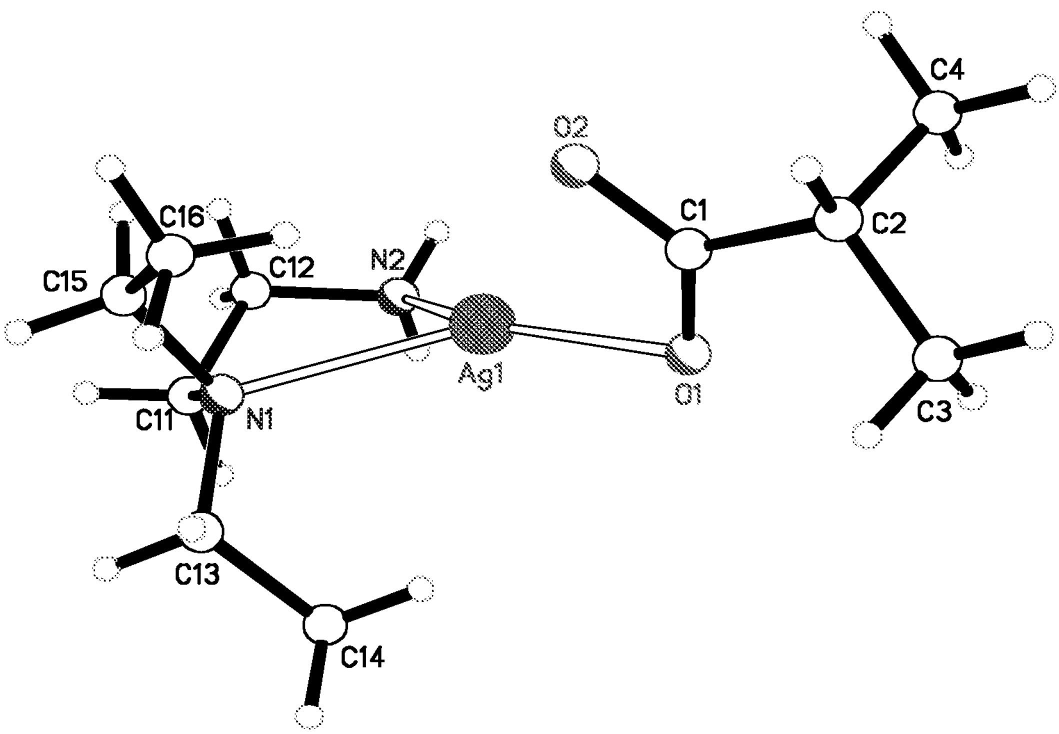

**FIGURE 6**

Log resistivity versus temperature graph

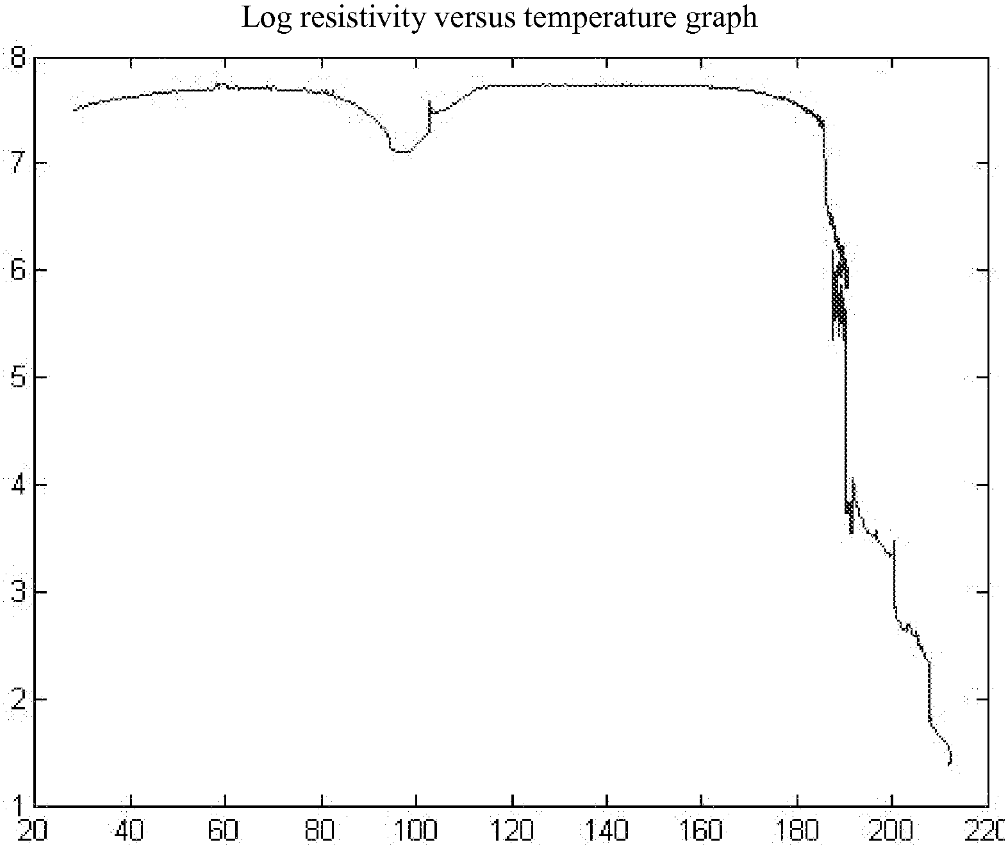

FIGURE 7

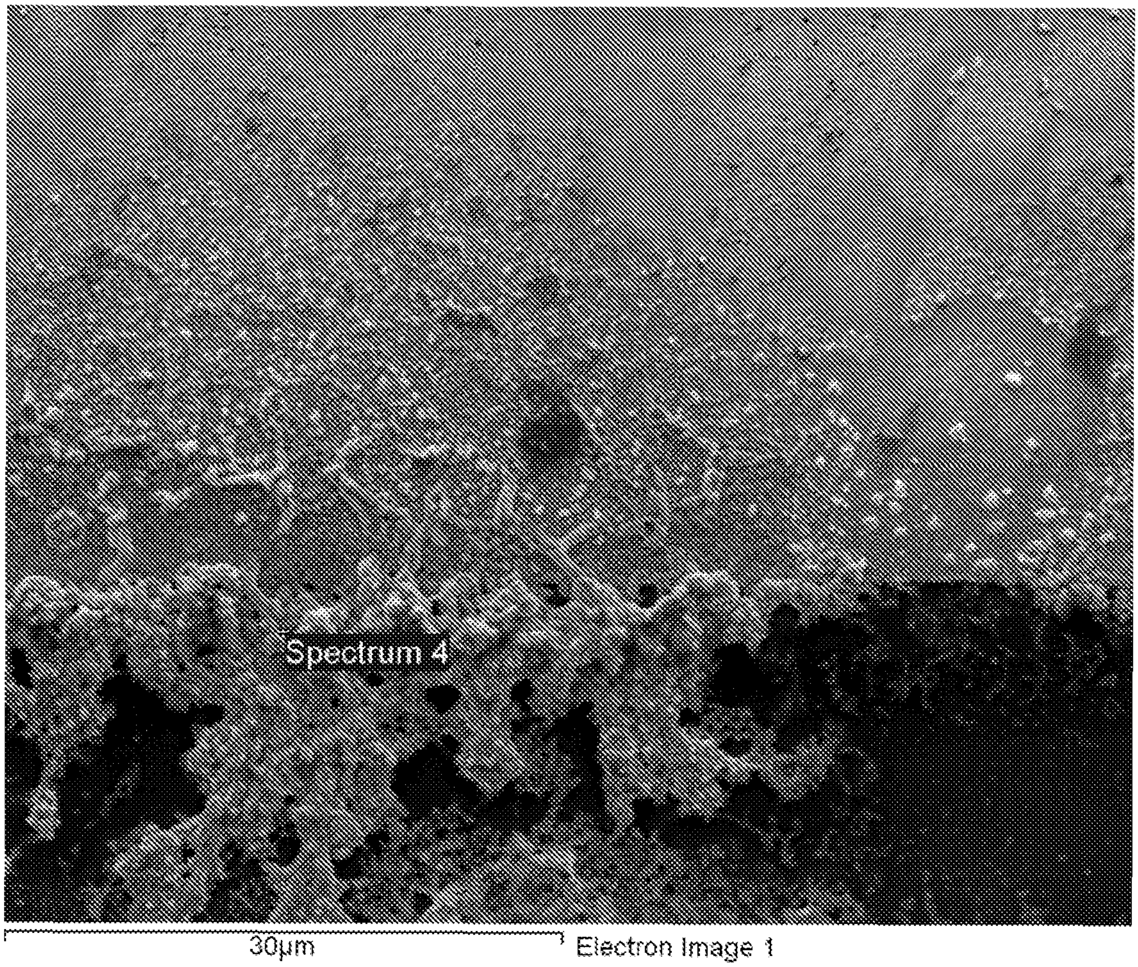

FIGURE 8

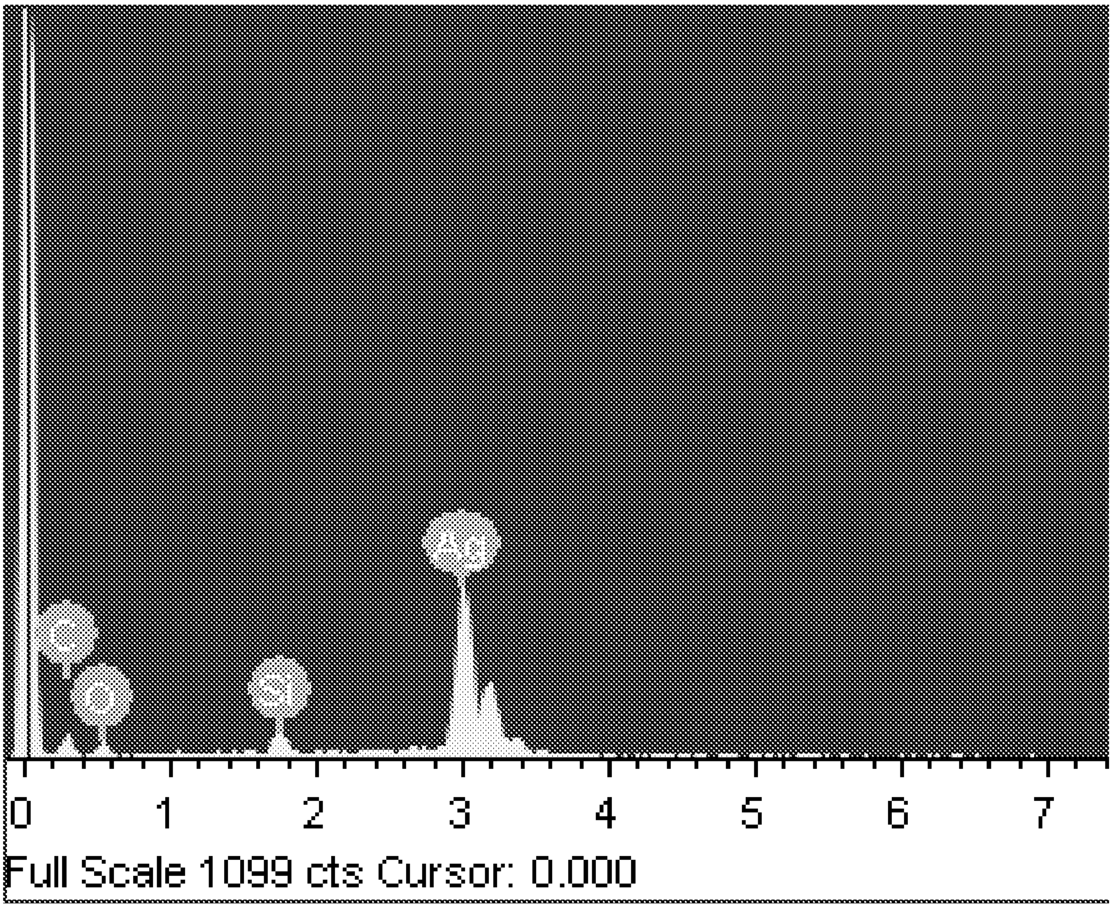

FIGURE 9

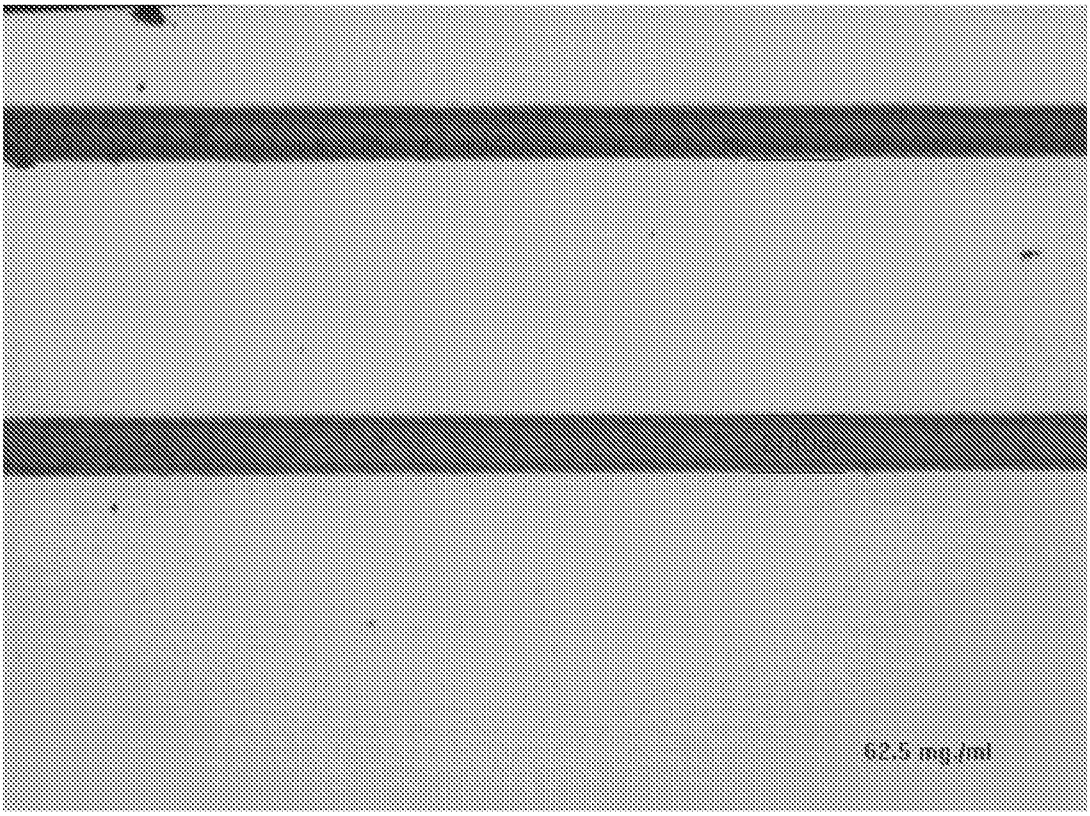

**FIGURE 10**

Log resistivity (arbitrary units) versus temperature (°C)

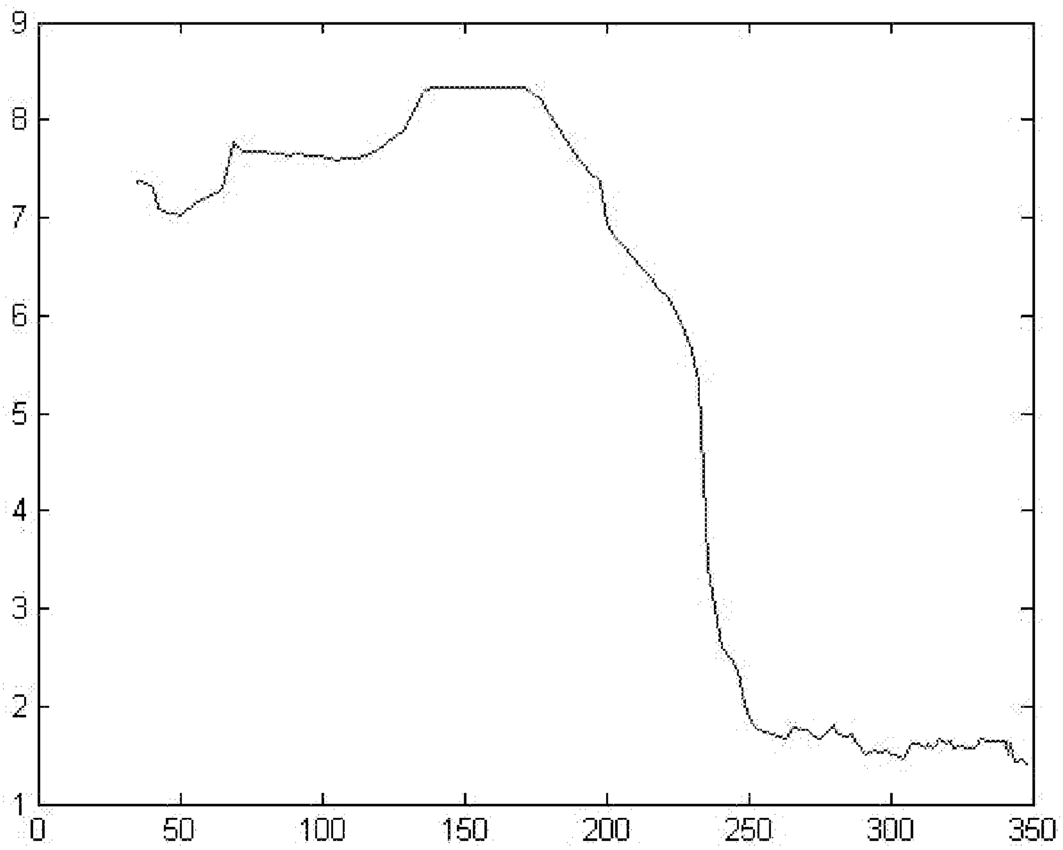

**FIGURE 11**

. Log resistivity (arbitrary units) versus temperature (°C)

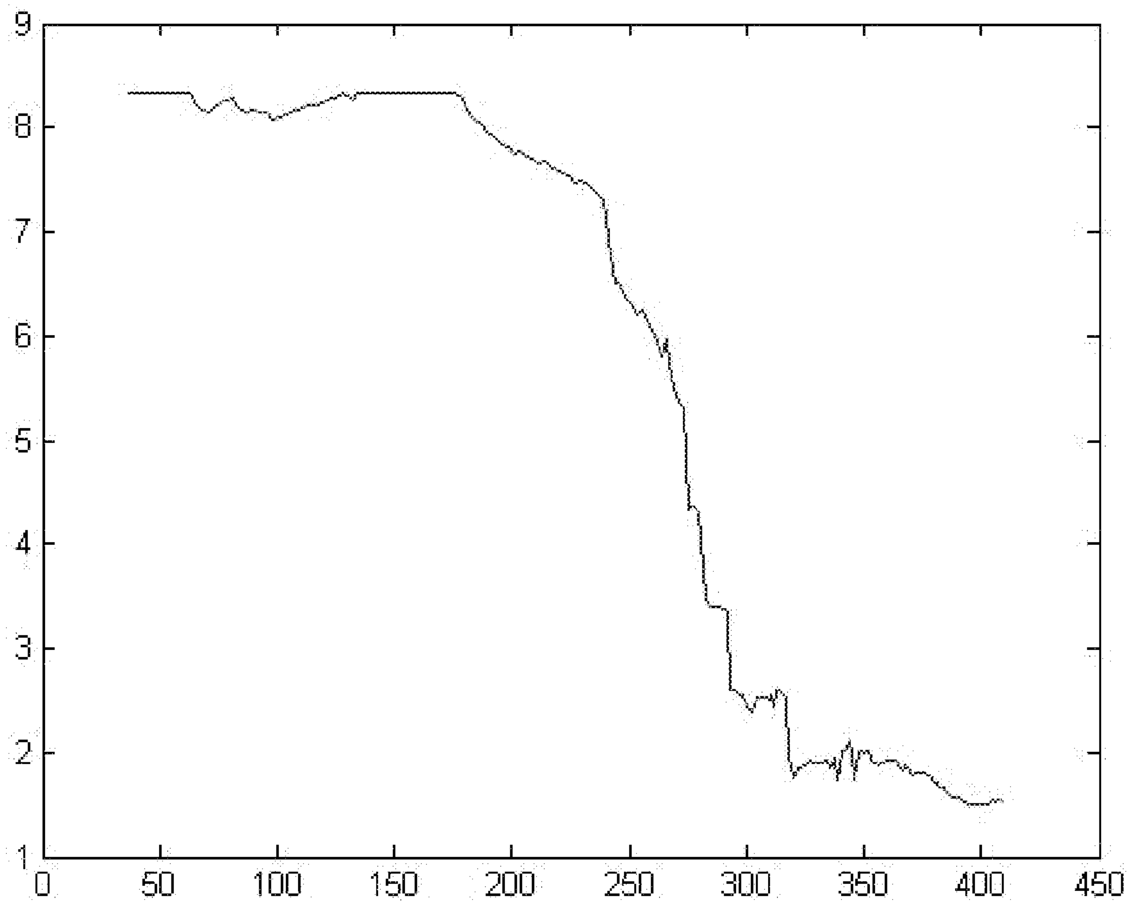

**FIGURE 12**

Log resistivity versus temperature

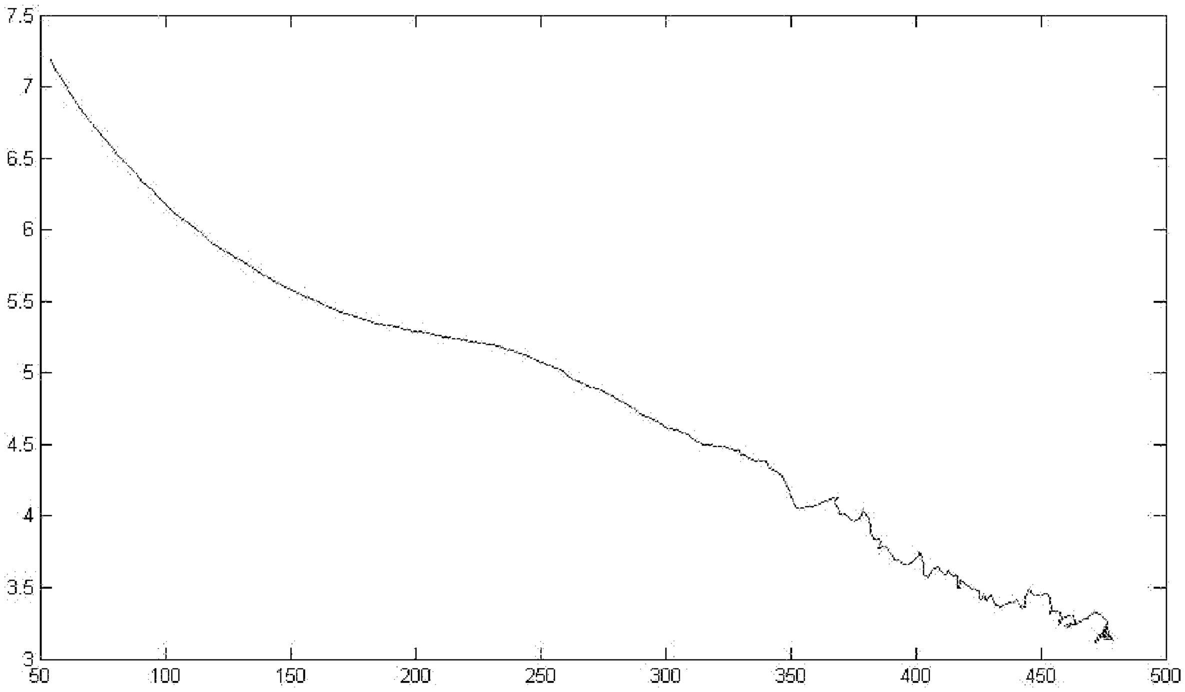

FIGURE 13

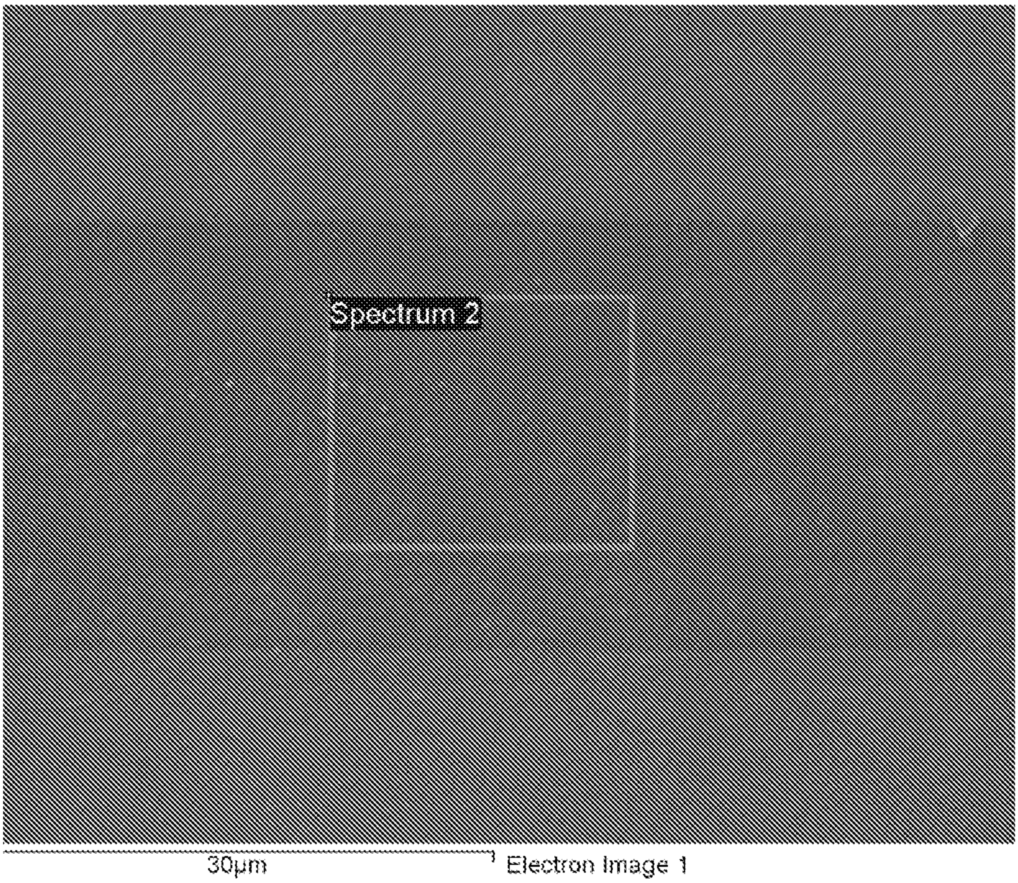

FIGURE 14

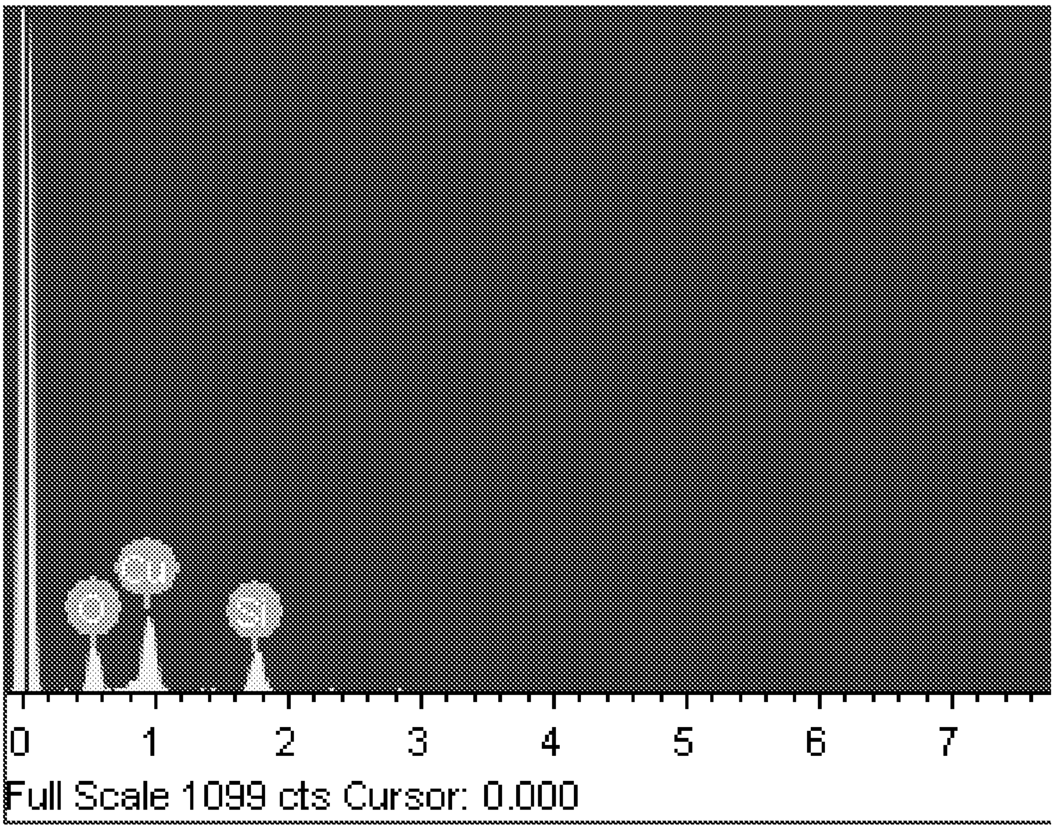

**FIGURE 15**

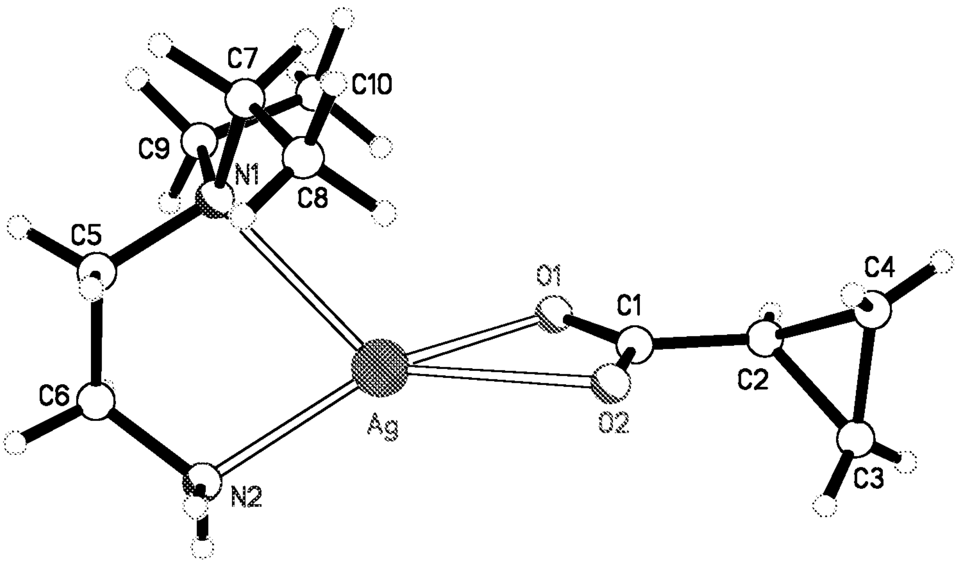

FIGURE 16

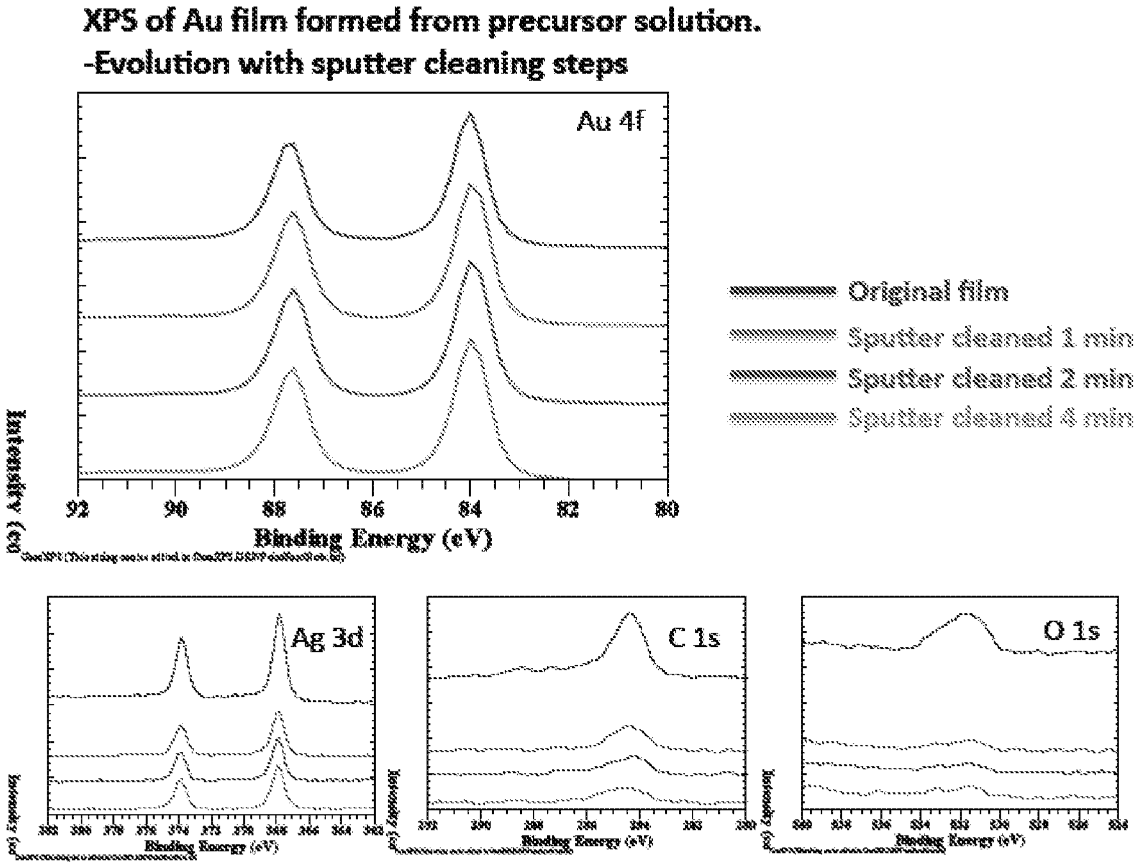
XPS of Au film formed from precursor solution.
-Evolution with sputter cleaning steps
Au 4f
Original film
Sputter cleaned 1 min
Sputter cleaned 2 min
Sputter cleaned 4 min
Intensity
Binding Energy (eV)
92
90
88
86
84
82
80
Ag 3d
C 1s
O 1s

FIGURE 17

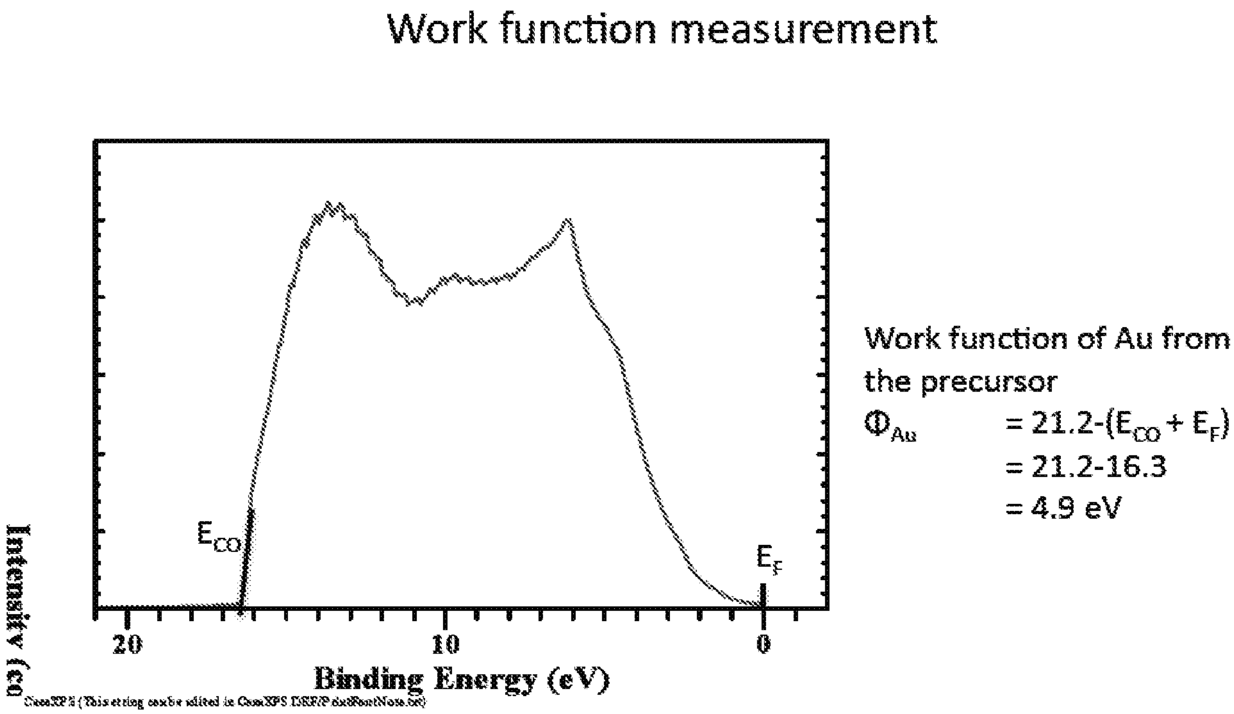
Work function measurement
Intensity (co
$E_{CO}$
$E_F$
20
10
0
Binding Energy (eV)
Work function of Au from the precursor
$\Phi_{Au}$ = 21.2-($E_{CO}$ + $E_F$)
= 21.2-16.3
= 4.9 eV

**FIGURE 18**

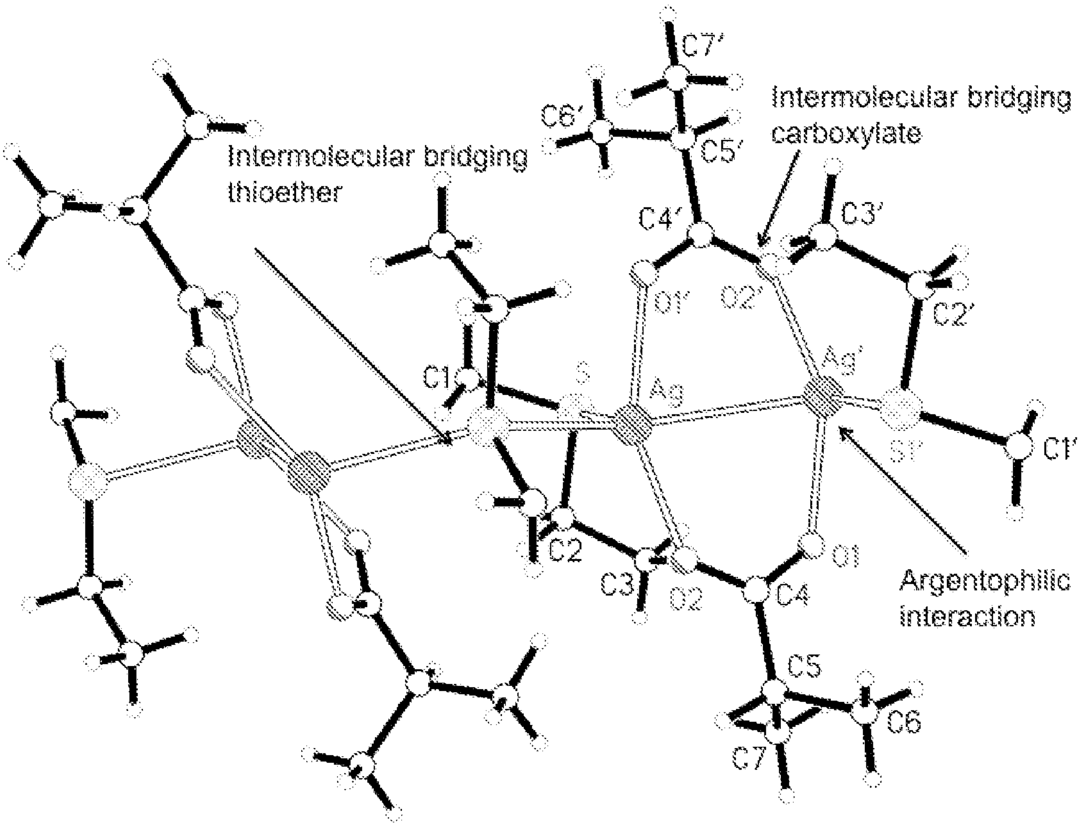
Intermolecular bridging thioether
Intermolecular bridging carboxylate
Argentophilic interaction

**FIGURE 19**

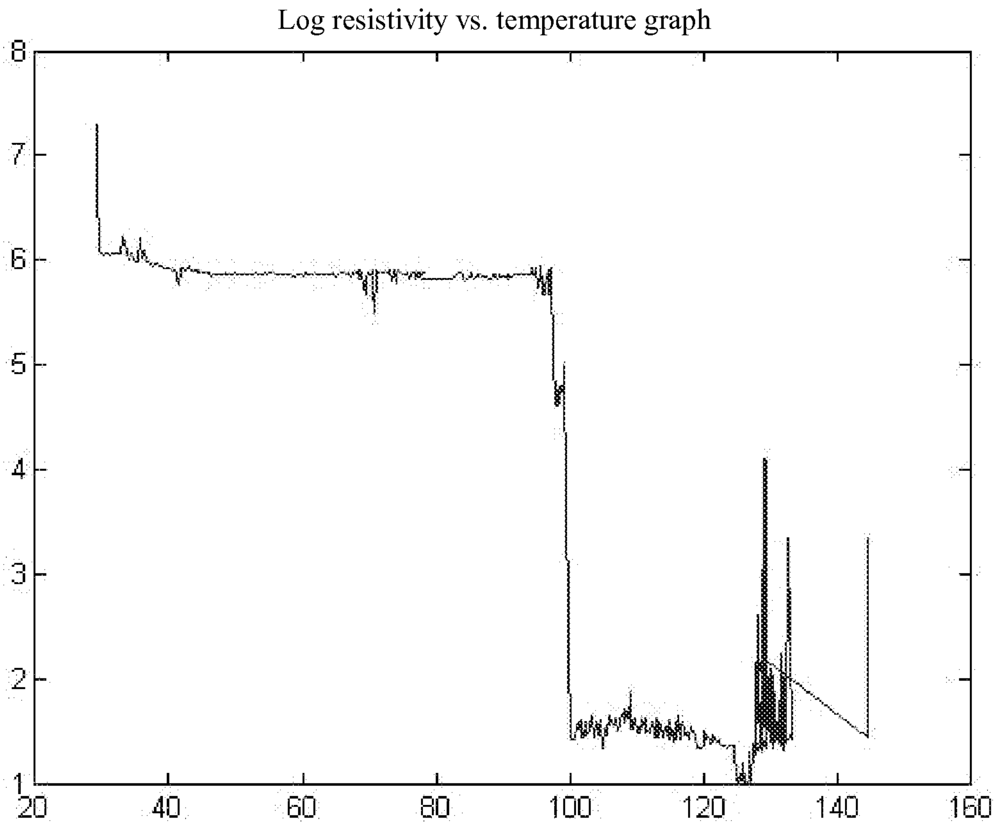
Log resistivity vs. temperature graph
8
7
6
5
4
3
2
1
20
40
60
80
100
120
140
160

FIGURE 20

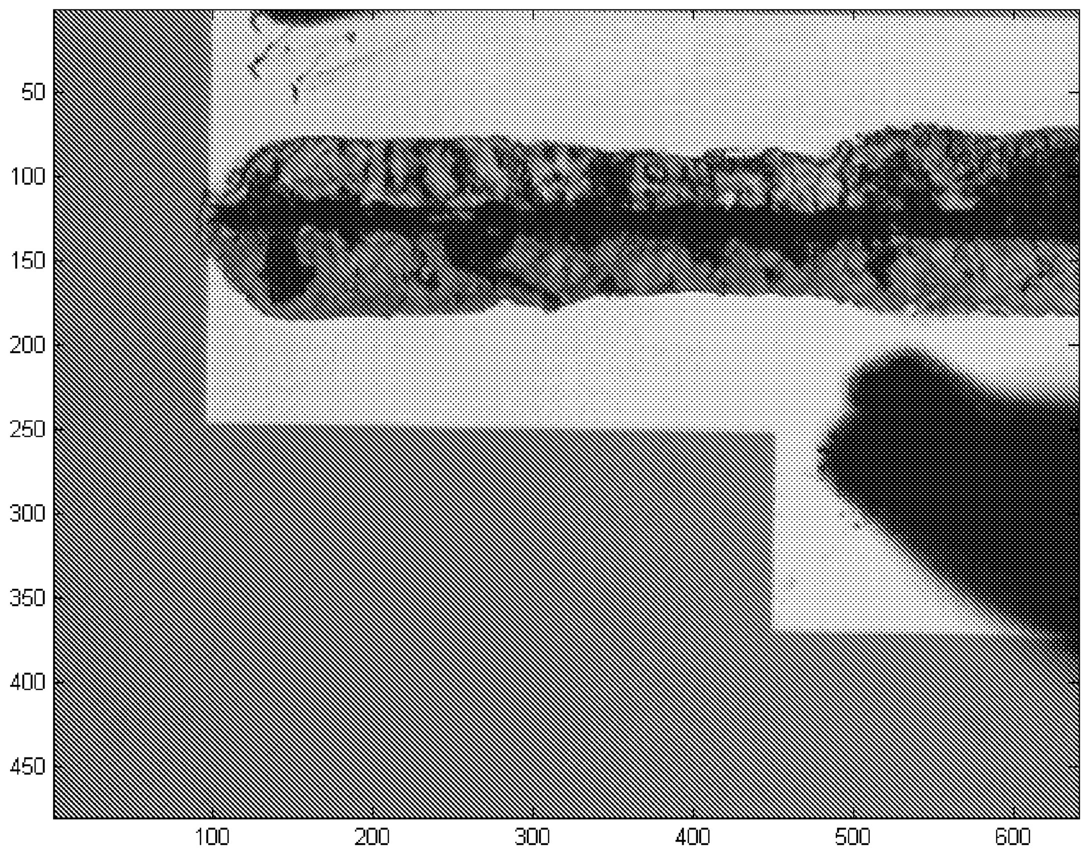

**FIGURE 21**

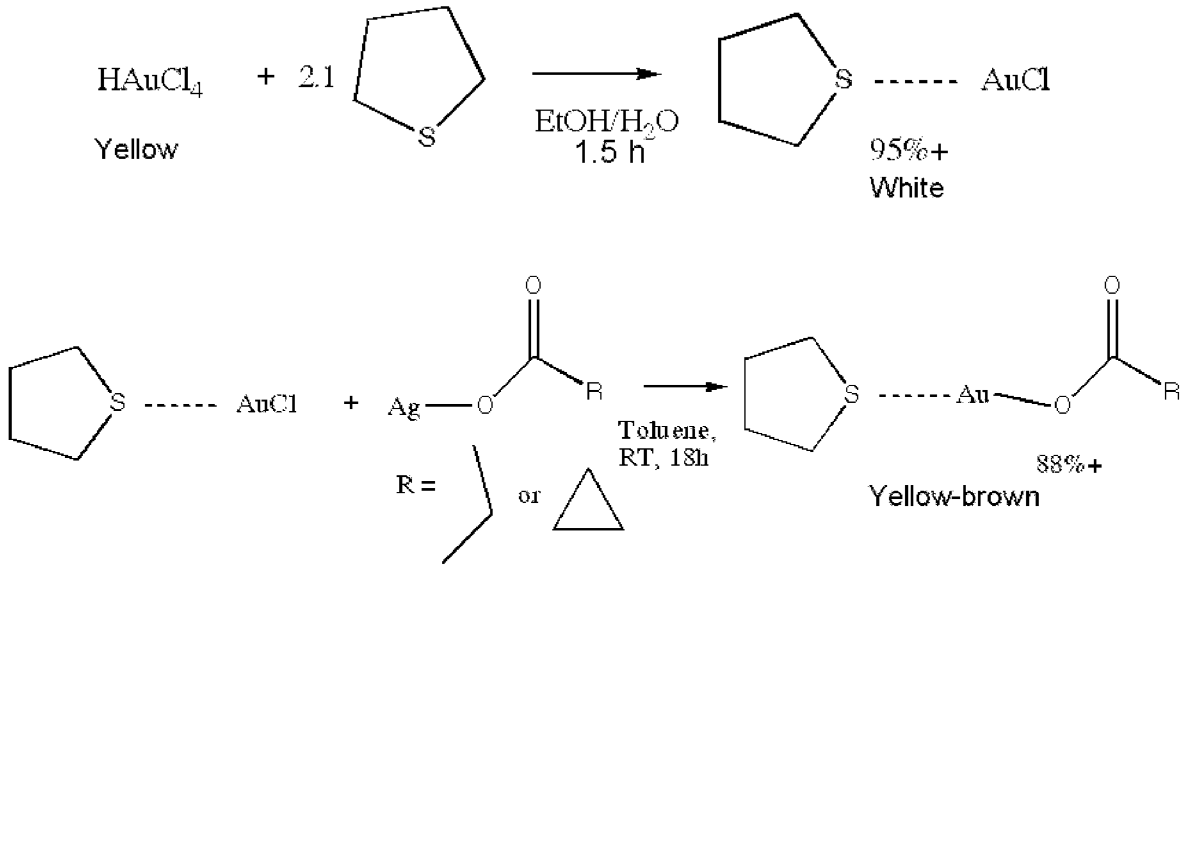
Yellow
+ 2.1
EtOH/H2O
1.5 h
95%+
White
+
Toluene,
RT, 18h
R =
or
88%+
Yellow-brown

**FIGURE 22**

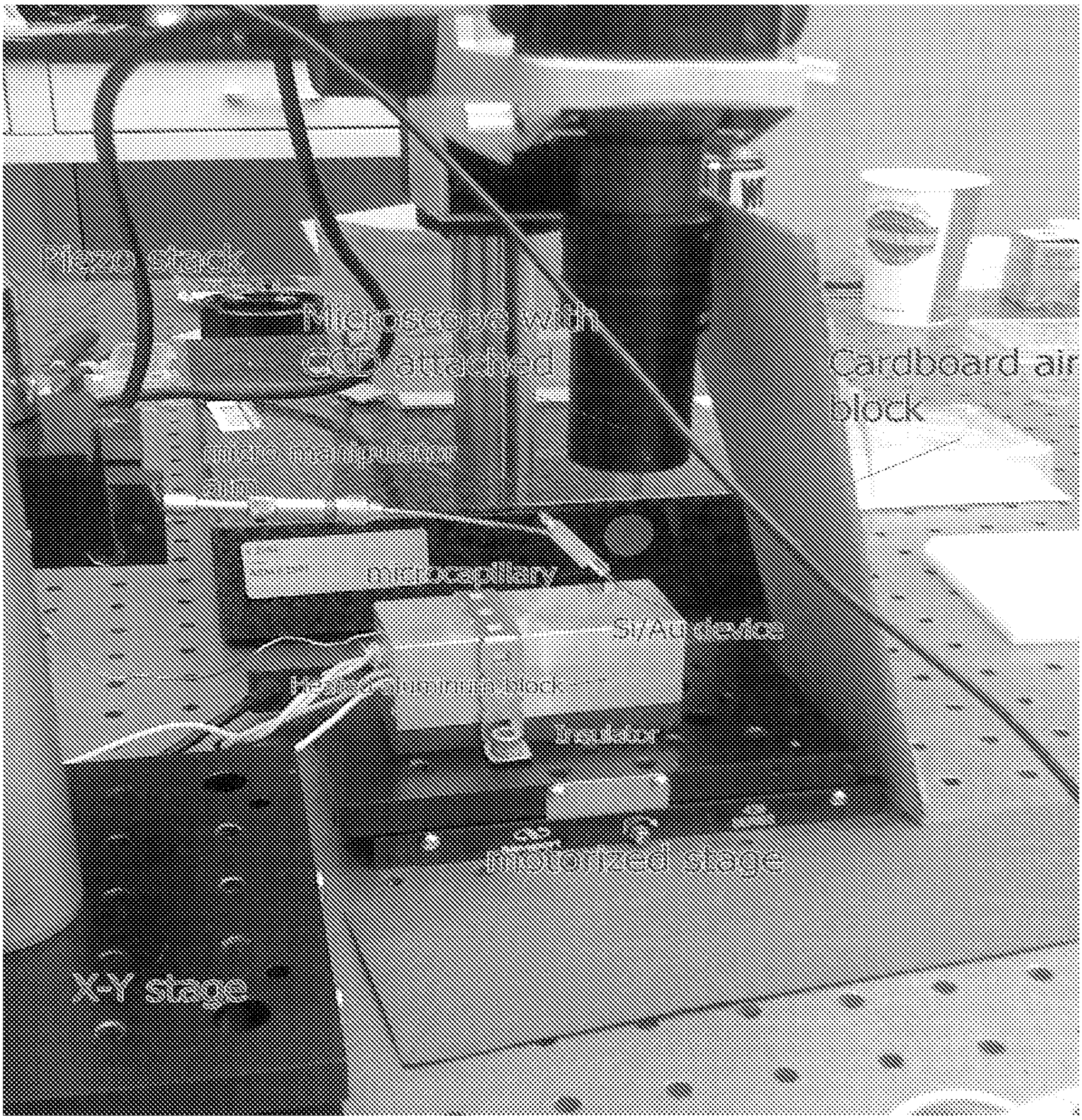
Piezo stack
Microscope with
CCD attached
Cardboard air
block
microcapillary
Si/Au device
Insulator
motorized stage
X-Y stage

FIGURE 23

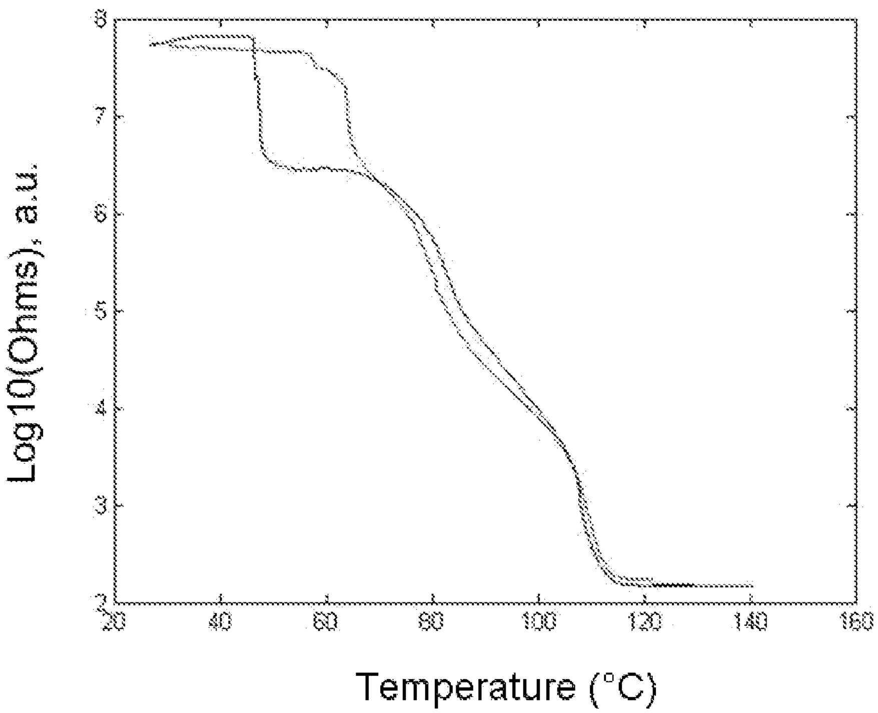


Red Line = Fresh Solution (100 mg/mL toluene)
Blue Line - Aged 24h

FIGURE 24

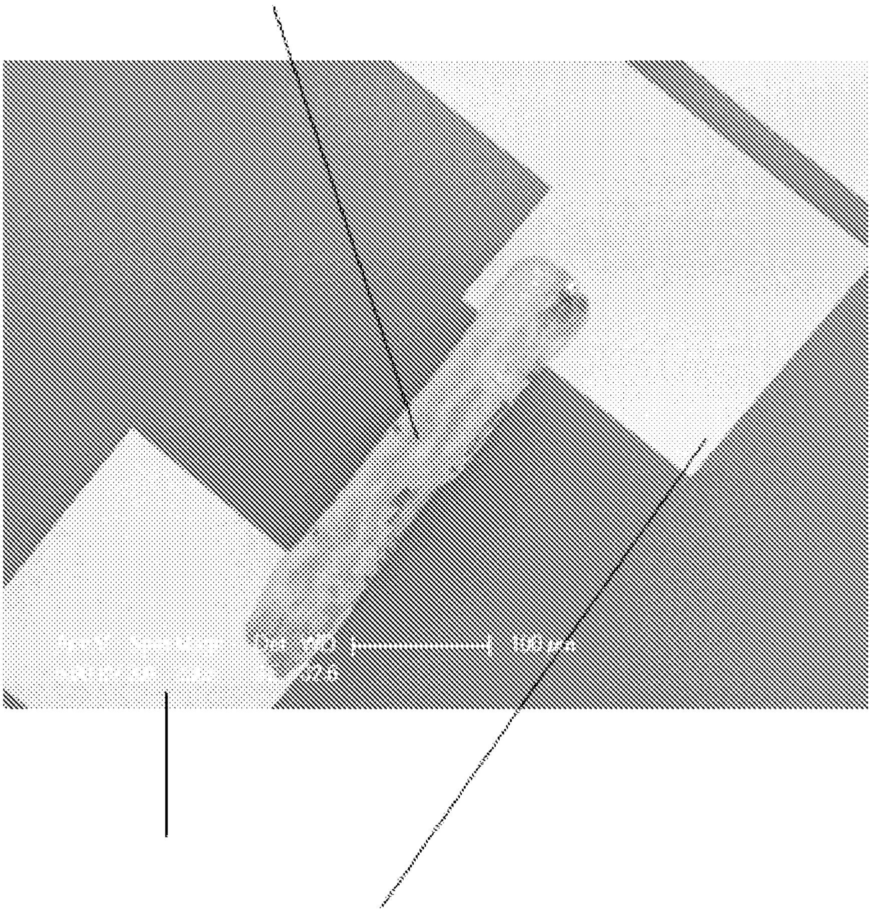

FIGURE 25

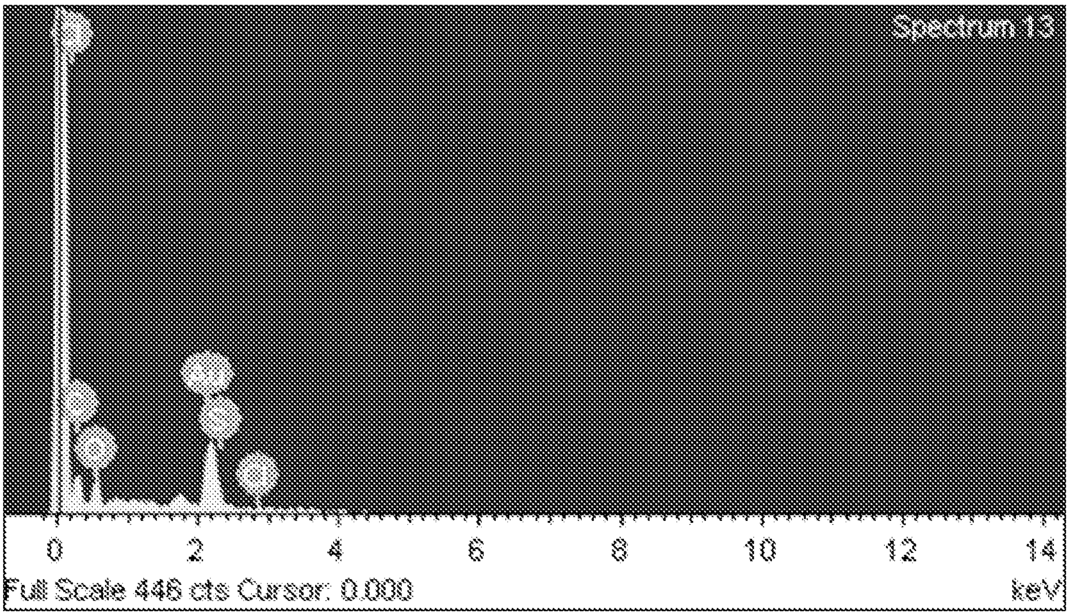


C = 7.46%

O = 5.31%

Au = 87.23%

FIGURE 26

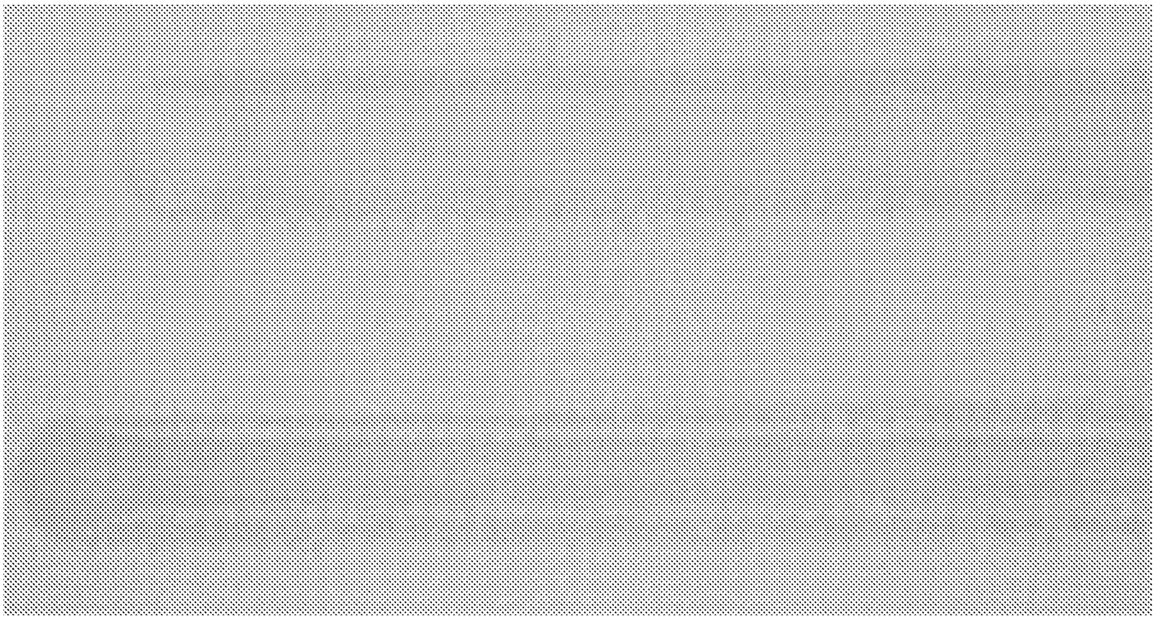

FIGURE 27

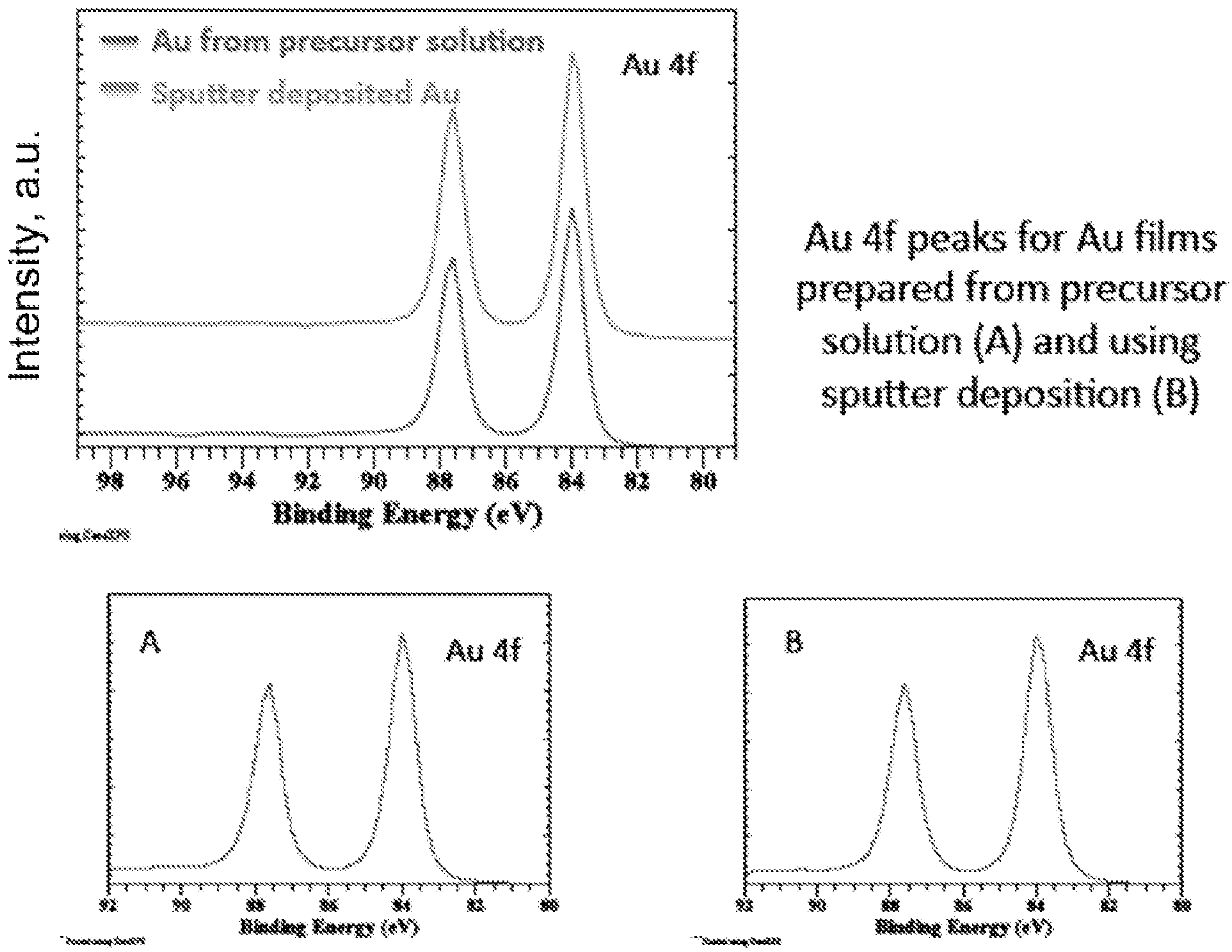
Au from precursor solution
Sputter deposited Au
Au 4f
Intensity, a.u.
98 96 94 92 90 88 86 84 82 80
Binding Energy (eV)
Au 4f peaks for Au films prepared from precursor solution (A) and using sputter deposition (B)
A
Au 4f
Binding Energy (eV)
B
Au 4f
Binding Energy (eV)

FIGURE 28

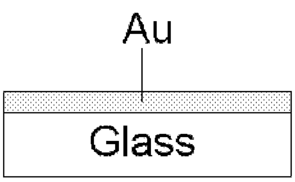


Solution spun-coated at 1000-1300 rmp
Concentration = 100mg/mL toluene

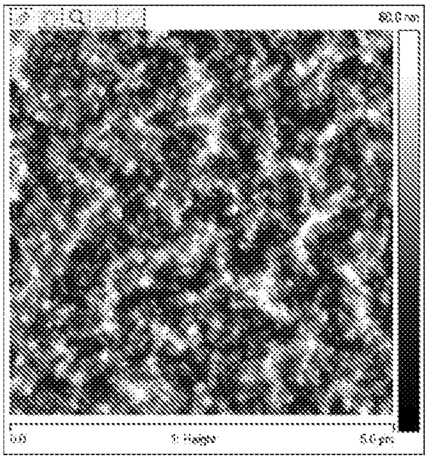

AFM image

RMS surface roughness 7.9nm

Conductivity Formula

$$\sigma = \frac{4.53(V)(t)}{I}$$

T = thickness, V = voltage, I = current

Thickness = 20, 35, 50 nm
Resistivity = 1.875 - 4.66 x $10^{-7}$ Ω/cm
Conductivity = 2.1 - 5.3 x $10^{6}$ S/cm
Bulk Gold Conductivity ~ 48.7 x $10^{6}$ S/cm

FIGURE 29

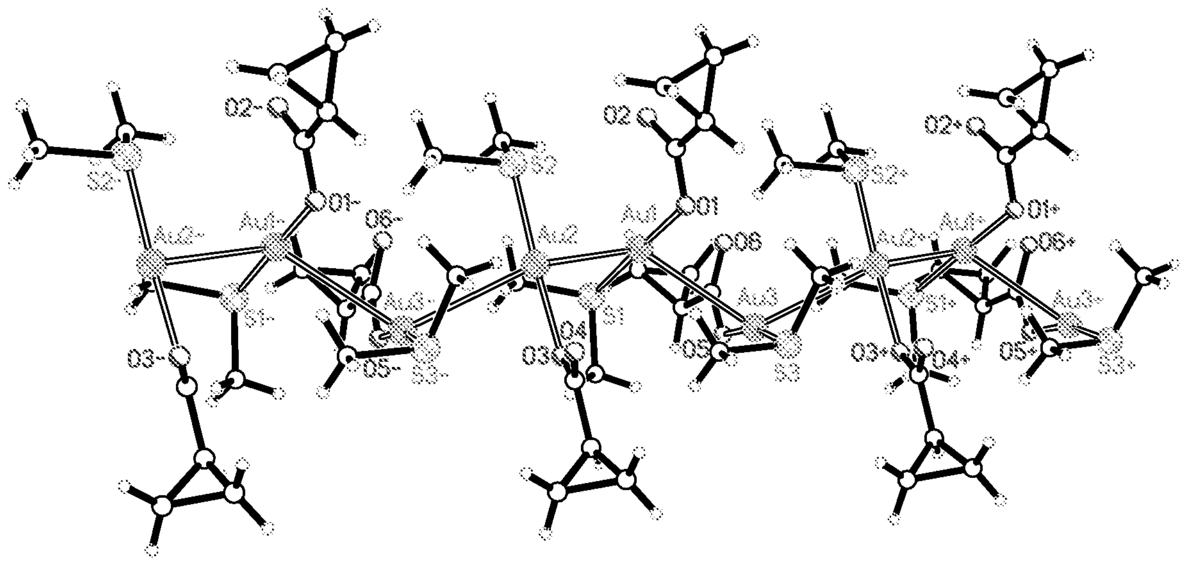

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 7270694 B
- US 7443027 B
- US 7491646 B
- US 7494608 B
- US 20100163810 A
- US 20080305268 A
- US 20060130700 A
- US 20030207568 A1
- US 7348365 B
- US 6821921 B
- US 7153635 B
- US 7445884 B
- US 6991894 B
- US 7524621 B
- US 7014979 B
- US 7629017 B
- US 6951666 B
- US 6818783 B
- US 6830778 B
- US 6036889 A
- US 5882722 A


### Non-patent literature cited in the description


- Fundamentals of Microfabrication. **MADOU.** The Science of Miniaturization. 2002
- **MARCH'S.** Advanced Organic Chemistry. 2007
- **LUKEHART.** Fundamental Transition Metal Organometallic Chemistry. Brooks/Cole, 1985
- **COTTON ; WILKINSON.** Advanced Inorganic Chemistry: A Comprehensive Text. John Wiley, 2000
- Direct-Write Technologies for Rapid Prototyping Applications, Sensors, Electronics, and Integrated Power Sources. Academic Press, 2002
- **B.D. GATES.** Flexible Electronics. *Science,* 20 March 2009, vol. 323, 1566-1567